(19) Europäisches Patentamt / European Patent Office / Office européen des brevets

(11) **EP 2 961 601 B1**

(12) **EUROPEAN PATENT SPECIFICATION**

(45) Date of publication and mention
of the grant of the patent:
**08.12.2021  Bulletin 2021/49**

(51) Int Cl.:
***B32B 27/30*** (2006.01)   ***B32B 27/18*** (2006.01)
***B32B 7/02*** (2019.01)   ***B32B 37/00*** (2006.01)
***B32B 37/10*** (2006.01)   *B44C 1/17* (2006.01)
*H01L 51/00* (2006.01)   *H01L 51/52* (2006.01)

(21) Application number: **14756801.8**

(22) Date of filing: **17.02.2014**

(86) International application number:
**PCT/US2014/016668**

(87) International publication number:
**WO 2014/133799 (04.09.2014 Gazette 2014/36)**

(54) **LAMINATION TRANSFER FILMS FOR FORMING EMBEDDED NANOSTRUCTURES**

LAMINIERUNGSTRANSFERFOLIEN ZUR HERSTELLUNG EINGEBETTETER NANOSTRUKTUREN

FILMS DE TRANSFERT DE STRATIFICATION POUR FORMER DES NANOSTRUCTURES INCLUSES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **27.02.2013   US 201313778276**

(43) Date of publication of application:
**06.01.2016   Bulletin 2016/01**

(60) Divisional application:
**18150180.0 / 3 332 964**

(73) Proprietor: **3M Innovative Properties Company**
St. Paul, MN 55133-3427 (US)

(72) Inventors:
• **FREE, Michael Benton**
  **Saint Paul, Minnesota 55133-3427 (US)**
• **WOLK, Martin B.**
  **Saint Paul, Minnesota 55133-3427 (US)**
• **VOGEL-MARTIN, Margaret M.**
  **Saint Paul, Minnesota 55133-3427 (US)**
• **SCHWARTZ, Evan L.**
  **Saint Paul, Minnesota 55133-3427 (US)**

• **MAZUREK, Mieczyslaw H.**
  **Saint Paul, Minnesota 55133-3427 (US)**
• **KAMRATH, Robert F.**
  **Saint Paul, Minnesota 55133-3427 (US)**
• **COLLIER, Terry O.**
  **Saint Paul, Minnesota 55133-3427 (US)**
• **BENSON, Olester Jr.**
  **Saint Paul, Minnesota 55133-3427 (US)**

(74) Representative: **Vossius & Partner Patentanwälte Rechtsanwälte mbB Siebertstrasse 3 81675 München (DE)**

(56) References cited:
**WO-A1-2012/115132      WO-A1-2012/115132
WO-A1-2014/014595      JP-A- 2008 137 187
JP-A- 2011 068 004      US-A1- 2010 104 807
US-A1- 2010 104 807      US-A1- 2010 151 207
US-A1- 2010 151 207**

• **None**

## Description

### Background

Nanostructures and microstructures on glass substrates are used for a variety of applications in display, lighting, architecture and photovoltaic devices. In display devices the structures can be used for light extraction or light distribution. In lighting devices the structures can be used for light extraction, light distribution, and decorative effects. In photovoltaic devices the structures can be used for solar concentration and antireflection. Patterning or otherwise forming nanostructures and microstructures on large glass substrates can be difficult and cost-ineffective.

US 2010/151207 describes a transfer film, in particular a hot embossing film, which includes a carrier film and a transfer layer portion having a structure layer, the transfer layer portion being arranged on the carrier film and being detachable from the carrier film, wherein it is provided that the carrier film has a master relief structure on its side towards the structure layer and the structure layer on its side towards the carrier film has a relief structure complementary to the master relief structure of the carrier film.

### Summary

Accordingly, a need exists for fabricating nanostructures and microstructures in a cost-effective manner on a continuous carrier film and then using the film to transfer or otherwise impart the structures onto glass substrates or other permanent receptor substrates. Furthermore, a need exists for fabricating transfer films with embedded nanostructures that are protected from exposure to handling and also to the environment, thus having high durability. Additionally, a need exists for fabricating nanostructures and microstructures over a large area to meet the needs, for example, of large digital displays and architectural glass.

The subject-matter of the present invention is defined by the features of independent claim 1. Further preferred embodiments of the present invention are defined in the dependent claims. In the following various aspects are disclosed which are useful for the understanding of the present invention.

In one aspect, a transfer film is disclosed that includes a sacrificial template layer having a first surface and a second surface having a structured surface opposite the first surface and a thermally stable backfill layer applied to the second surface of the sacrificial template layer. The thermally stable backfill layer has a structured surface conforming to the structured surface of the sacrificial template layer and the sacrificial template layer comprises inorganic nanomaterials and sacrificial material. The sacrificial material of the sacrificial template layer is capable of being cleanly baked out while leaving a densified layer of inorganic nanomaterials on the structured surface of the thermally stable backfill layer.

In another aspect, a transfer film is disclosed that includes a support substrate having a releasable surface, a sacrificial template layer having a first surface applied to the releasable surface of the support substrate and a second surface opposite the first surface. The second surface includes a structured surface. The disclosed transfer film also includes a thermally stable backfill layer disposed upon the second surface of the sacrificial template layer. The thermally stable backfill layer has a structured surface conforming to the structured surface of the template layer and the template layer comprises inorganic nanomaterials and sacrificial material. After the removal of the support substrate, the sacrificial material of the sacrificial template layer is capable of being cleanly baked out while leaving a densified layer of inorganic nanomaterials on the structured surface of the thermally stable backfill layer.

According to the present invention, a transfer film is disclosed that includes a sacrificial support substrate and a sacrificial template layer having a first surface applied to the sacrificial support substrate and a second surface opposite the first surface. The second surface comprises a structured surface comprising a sacrificial materials component and a thermally stable materials component. The disclosed transfer film also includes a thermally stable backfill layer disposed upon the second surface of the sacrificial template layer. The thermally stable backfill layer has a structured surface conforming to the structured surface of the template layer and the thermally stable materials component of the sacrificial template layer includes a binder, wherein the binder is formed from a binder precursor comprising metal alkoxide or polysilazanes. The thermally stable materials component may further comprise inorganic nanoparticles.

In this disclosure:

"backfill materials" or "backfill layers" refers to layers of materials that fill in irregular or structured surfaces to produce a new surface that may be used as a base to build additional layered elements and is thermally stable;

"bake-out" refer to the process of substantially removing sacrificial material present in a layer by pyrolysis or combustion while leaving thermally stable materials substantially intact (backfill, inorganic nanomaterials, receptor substrate);

"bake-out temp" refer to the maximum temperature reached during the process of substantially removing sacrificial materials in a layer by pyrolysis or combustion while leaving thermally stable materials substantially intact (backfill, inorganic nanomaterials, receptor substrate);

"combust" or "combustion" refers to a process of heating a layer that comprises organic materials in an oxidizing atmosphere so that organic materials undergo a chemical reaction with the oxidant

"densified layer of nanomaterials" refers to a layer with an increased volume fraction of nanomaterials resulting from the pyrolysis or combustion of a layer containing a polymer or other organic constituents and inorganic nanomaterials. The densified layer may comprise nanomaterials, partially-fused nanomaterials, chemically sintered nanomaterials, a fused glass-like material resulting from a sintering process, or a frit. It may further comprise residual non-particulate organic or inorganic material that acts as a sintering agent or binder;

"nanostructures" refers to features that range from about 1 nm to about 1000 $\mu$m in their longest dimension and includes microstructures;

"pyrolyze" or "pyrolysis" refers to a process of heating a layer that comprises inorganic nanomaterials in an inert atmosphere so that organic materials in the article decompose by homo- or heterolytic bond cleavage, bond rearrangement, or other processes that serve to fragment organic molecules and create low molecular weight volatile organic products;

"structured surface" refers to a surface that includes nanostructures that can be in a regular pattern or random across the surface; and

"thermally stable" refers to materials that remain substantially intact during the removal of sacrificial materials.

The above summary is not intended to describe each disclosed embodiment or every implementation of the present disclosure. The figures and the detailed description below more particularly exemplify illustrative examples, wherein the subject-matter of the invention is defined by the features of the claims.

Brief Description of the Drawings

Throughout the specification reference is made to the appended drawings, where like reference numerals designate like elements, and wherein:

Fig. 1A is a schematic drawing of a conformal thin densified layer of nanomaterials on a structured backfill layer.
Fig. 1B is a schematic drawing of partial planarization of a backfill layer by a coating containing nanomaterials.
Fig. 1C is a schematic drawing of complete planarization of a backfill layer by a coating containing nanomaterials.
Figs. 2 to 6 are schematic drawings of embodiments of disclosed transfer films having embedded nanostructure.
Fig. 7 is a chart of a thermal gravimetric analysis of two polymers - one comprising adamantane moieties, and the other poly(methyl methacrylate).
Fig. 8A is a schematic diagram showing densification of a nanoparticle-containing sacrificial substrate layer with increasing time and/or temperature.
Fig. 8B is a schematic diagram showing the use of densification of a nanoparticle-containing sacrificial template layer to make an embedded nanostructure article.
Fig. 9 is a photomicrograph of an embodiment of a disclosed transfer film.
Fig. 10 is a schematic of the process used in Example 5.

The figures are not necessarily to scale. Like numbers used in the figures refer to like components. However, it will be understood that the use of a number to refer to a component in a given figure is not intended to limit the component in another figure labeled with the same number.

**Detailed Description**

In the following description, reference is made to the accompanying set of drawings that form a part of the description hereof and in which are shown by way of illustration several specific embodiments. It is to be understood that other embodiments are contemplated and may be made without departing from the scope or spirit of the present invention. The following detailed description, therefore, is not to be taken in a limiting sense.

Unless otherwise indicated, all numbers expressing feature sizes, amounts, and physical properties used in the specification and claims are to be understood as being modified in all instances by the term "about." Accordingly, unless indicated to the contrary, the numerical parameters set forth in the foregoing specification and attached claims are approximations that can vary depending upon the desired properties sought to be obtained by those skilled in the art utilizing the teachings disclosed herein. The use of numerical ranges by endpoints includes all numbers within that range (e.g. 1 to 5 includes 1, 1.5, 2, 2.75, 3, 3.80, 4, and 5) and any range within that range.

Structured lamination transfer films and methods are disclosed that enable the fabrication of structured surfaces that include embedded nanostructures using a lamination process. Also disclosed are articles resulting from the lamination of the disclosed transfer films to a receptor substrate. The methods involve replication of a film, layer, or coating in order to form a structured template layer. The replication can be performed against a master using any microreplication techniques known to those of ordinary skill in the art of microreplication. These techniques can include, for example, embossing, cast and cure of a prepolymer resin (using thermal or photochemical initiation), or hot melt extrusion. Typically microreplication involves casting of a photocurable prepolymer solution against a template followed by photopolymerization of the prepolymer solution. In this disclosure, "nanostructures" refers to structures that have features that are less than 1 μm, less than 750 nm, less than 500 nm, less than 250 nm, less than 100 nm, less than 50 nm, less than 10 nm, or even less than 5 nm down to about 1 nm and also includes "microstructures" which refer to structures that have features that are less than 1000 μm, less than 100 μm, less than 50 μm, or even less than 5 μm. Hierarchical refers to structures with more than one size scale that include microstructures with nanostructures (e.g. a microlens with nanoscale moth eye antireflection features). The terms "nanostructures" and "microstructures" can be used interchangeably. Lamination transfer films have been disclosed, for example, in Applicants' pending unpublished application, U. S. Pat. Publ. No. US2014/0021492, entitled, "STRUCTURED LAMINATION TRANSFER FILMS AND METHODS", filed July 20, 2012; U.S.S.N. 13/723,716 entitled, "PATTERNED STRUCTURED TRANSFER FILM", and U.S.S.N. 13/723,675, entitled METHODS OF USING NANOSTRUCTURED TRANSFER TAPE AND ARTICLES MADE THEREFROM, both filed on December 21, 2012.

The disclosed patterned structured transfer films can include inorganic materials such as, for example, inorganic nanomaterials. The inorganic nanomaterials can be present in a sacrificial layer that can be cleanly baked out leaving a densified layer of nanomaterials. In some embodiments, the densified layer of nanomaterials can completely or partially fuse into a glass-like material. The densified layer of nanomaterials can have substantial void volume. The densified layer of nanomaterials can be transparent and can have a high index of refraction compared to surrounding layers of the disclosed transfer films. Inorganic nanoparticles can be present in one or more embedded layers, each layer having a different index of refraction influenced by the type and concentration of nanoparticles present in the layer.

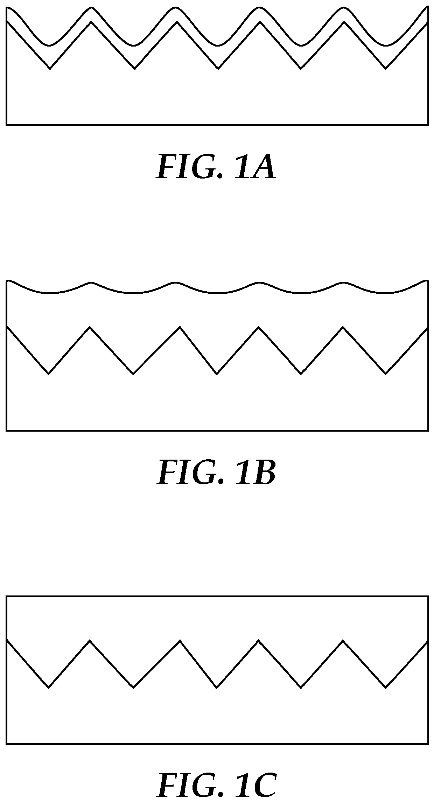

Figs. 1A-1C are schematic drawings of densified layers of inorganic nanomaterials on a structured backfill material. In Fig. 1A, the densified layer of nanomaterials conforms to the structured backfill layer and forms a continuous layer that can be conductive. There is essentially no planarization of the structured backfill layer with this arrangement. In some embodiments, the configuration of densified layers that conform to the structured backfill layer can be discontinuous or nonconductive. Or, alternatively, the amount of inorganic nanomaterials present can be enough to fill the valleys of the structured surface but not the peaks, leaving discontinuous pockets of inorganic nanomaterials in the valleys of the structure. Fig. 1B shows a configuration of a densified layer of inorganic nanomaterials that partially planarizes the structured backfill layer and Fig. 1C shows a configuration of a densified layer of inorganic nanomaterials that completely planarizes the structured backfill layer.

The constructions that include an embedded densified layer of nanomaterials can be transferred to substrates such as glass, silicon, semiconductor wafers, or other substrates to form laminated film constructions that can have a lower layer of nanostructures that include a densified layer of nanomaterials and have refractive index $r_1$ and an upper layer of nanostructures that can have refractive index $r_2$. Many constructions that can be produced using the disclosed transfer films are difficult to make by other processes. The disclosed constructions can be used to form optical elements as a part of electronic devices such as, for example, active-matrix organic light emitting diodes (AMOLEDs), organic light emitting diode lighting elements, liquid crystal displays, inorganic light emitting diodes (LEDs), LED lighting elements, image sensors such as charge coupled devices (CCDs), or lighting elements such as light bulbs (e.g., halogen).

The materials present in a sacrificial layer have a binder present in that layer. The binders include metal alkoxides such as alkyl titanates, alkyl zirconates, and alkyl silicates.

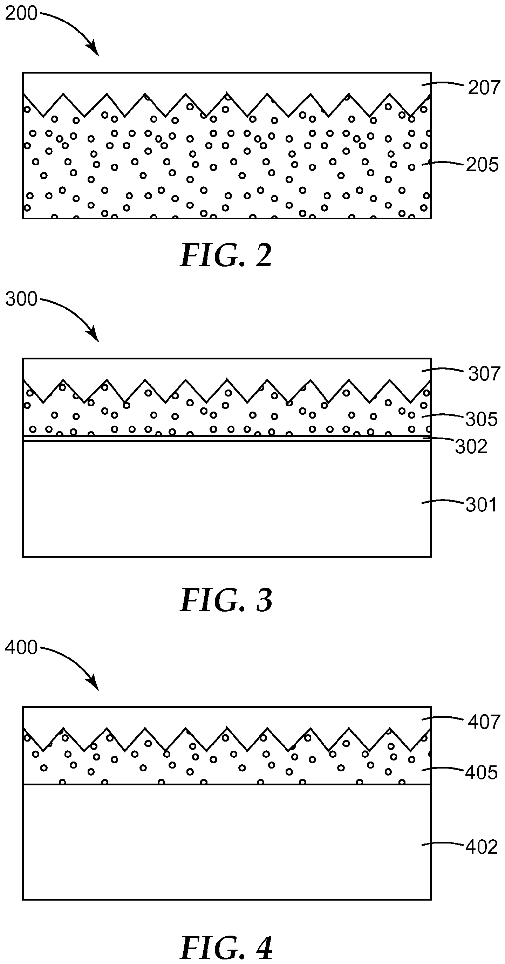

Figs. 2 to 6 are schematic drawings of embodiments of disclosed transfer films having embedded nanostructure. Fig. 2 is a drawing of an embodied transfer film 200 that includes sacrificial template layer 205 that has a structured surface and that includes inorganic nanomaterials and sacrificial material and thermally stable backfill layer 207 disposed upon and in contact with the structured surface of sacrificial template layer 205.

The embodied transfer film 300 shown in Fig. 3 includes support substrate 301 that has releasable surface 302. Sacrificial template layer 305 is disposed upon releasable surface 302 of support substrate 301 and includes inorganic nanomaterials and sacrificial material. Thermally stable backfill layer 307 is disposed upon and in contact with the structured surface of sacrificial template layer 305.

Another embodied transfer film is shown in Fig. 4. Transfer film 400 includes sacrificial support substrate 402. Sacrificial template layer 405 is disposed upon sacrificial support substrate 402 and includes inorganic nanomaterials and sacrificial material. Thermally stable backfill layer 407 is disposed upon and in contact with the structured surface of sacrificial template layer 405.

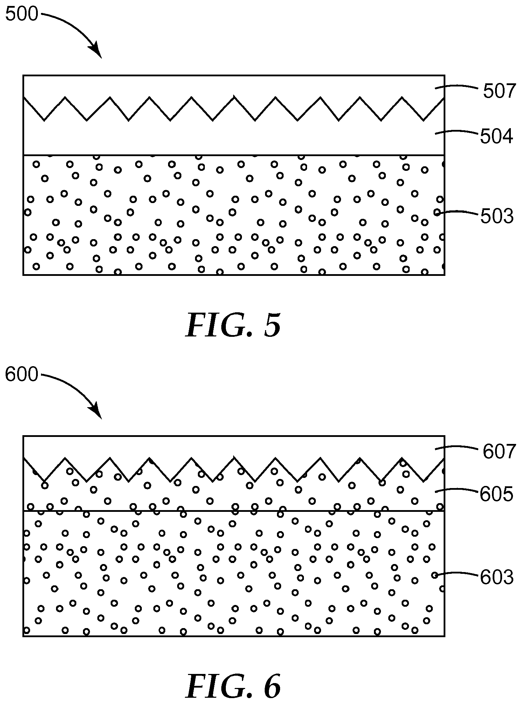

Fig. 5 shows an embodied transfer film 500. Transfer film 500 has sacrificial support substrate that includes inorganic nanomaterials 503 and sacrificial material. Sacrificial support substrate 503 has disposed upon it sacrificial template layer 504 that has a first surface applied to sacrificial support substrate 503 and second surface opposite the first surface that comprises a structured surface. The second structured surface of sacrificial template layer 504 is planarized by thermally stable backfill layer 507.

Another embodiment of a disclosed transfer film is shown in the schematic of Fig. 6. Transfer film 600 includes sacrificial support substrate 603 that includes inorganic nanomaterials and sacrificial material. Sacrificial support substrate 603 has disposed upon it sacrificial template layer 605, also containing inorganic nanomaterials and sacrificial material that has a first surface applied to sacrificial support substrate 603 and second surface opposite the first surface that comprises a structured surface. The second structured surface of sacrificial template layer 605 is planarized by thermally stable backfill layer 607.

The transfer films shown in Figs. 2-6 can be used to transfer embedded nanostructures onto receptor substrates such as active matrix OLED (AMOLED) backplanes, AMOLED color filters on array substrates, or OLED solid state lighting element substrates. These nanostructures can enhance light extraction from the OLED devices, alter the light distribution pattern, improve the angular color uniformity of the devices, or some combination thereof.

Materials

Support Substrates

The support substrate or carrier substrate can be embodied as a flexible film providing mechanical support for the other layers. One example of a carrier film is polyethylene terephthalate (PET). Various polymeric film substrates comprised of various thermosetting or thermoplastic polymers are suitable for use as the support substrate. The carrier may be a single layer or multilayer film. Illustrative examples of polymers that may be employed as the carrier layer film include (1) fluorinated polymers such as poly(chlorotrifluoroethylene), poly(tetrafluoroethylene-cohexafluoropropylene), poly(tetrafluoroethylene-co-perfluoro(alkyl)vinylether), poly(vinylidene fluoride-cohexafluoropropylene); (2) ionomeric ethylene copolymers poly(ethylene-co-methacrylic acid) with sodium or zinc ions such as SURLYN-8920 Brand and SURLYN-9910 Brand available from E. I. duPont Nemours, Wilmington, DE.; (3) low density polyethylenes such as low density polyethylene; linear low density polyethylene; and very low density polyethylene; plasticized vinyl halide polymers such as plasticized poly(vinychloride); (4) polyethylene copolymers including acid functional polymers such as poly(ethylene-co- acrylic acid) "EAA", poly(ethylene-co-methacrylic acid) "EMA", poly(ethylene-co-maleic acid), and poly(ethylene-co-fumaric acid); acrylic functional polymers such as poly(ethylene-co-alkylacrylates) where the alkyl group is methyl, ethyl, propyl, butyl, et cetera, or $CH3 (CH2)n$- where n is 0 to 12, and poly(ethylene-co-vinylacetate) "EVA"; and (5) (e.g.) aliphatic polyurethanes. The carrier layer is typically an olefinic polymeric material, typically comprising at least 50 wt % of an alkylene having 2 to 8 carbon atoms with ethylene and propylene being most commonly employed. Other body layers include for example poly(ethylene naphthalate), polycarbonate, poly(meth)acrylate (e.g., polymethyl methacrylate or "PMMA"), polyolefins (e.g., polypropylene or "PP"), polyesters (e.g., polyethylene terephthalate or "PET"), polyamides, polyimides, phenolic resins, cellulose diacetate, cellulose triacetate (TAC), polystyrene, styrene-acrylonitrile copolymers, cyclic olefin copolymers, epoxies, and the like. In some embodiments, the support substrate can include paper, release-coated paper, non-wovens, wovens (fabric), metal films, and metal foils.

In some embodiments, the support substrate can include sacrificial materials. Sacrificial materials, typically sacrificial layers, can be pyrolyzed by subjecting them to thermal conditions that can vaporize substantially all of the organic material present in the sacrificial layers. Sacrificial layers can also be subjected to combustion to burn out all of the organic material present in the sacrificial layer. Typically, a clear, high-purity polymer, such as poly(methyl methacrylate), poly(ethyl acrylate-co-methyl methacrylate), can be used as the sacrificial material. Useful sacrificial materials leave very low organic residuals (ash) after pyrolysis or combustion at the bake-out temperature.

In some embodiments, the sacrificial support substrate of a disclosed transfer film can be coated with a releasable material on one surface. After making the rest of the transfer film and laminating the transfer film to a receptor substrate to form a laminate, the sacrificial support substrate can be removed from the laminate by peeling it away from the surface which it is supporting in the transfer film. In this embodiment, the sacrificial support material need not be pyrolyzed or combusted to be removed and can include any of the materials described above as support substrate materials.

Sacrificial Template Layer

The sacrificial template layer is the layer that can impart structure to the backfill layer. The sacrificial template layer typically has at least one structured surface. The sacrificial template layer can be formed through embossing, replication processes, extrusion, casting, or surface structuring, for example. The structured surface can include nanostructures, microstructures, or hierarchical structures. Nanostructures comprise features having at least one dimension (e.g., height, width, or length) less than or equal to one micron. Microstructures comprise features having at least one dimension (e.g., height, width, or length) less than or equal to one millimeter. Hierarchical structures are combinations of two size scales of structures, for example, nanostructures and microstructures. In some embodiments, the sacrificial template layer can be compatible with patterning, actinic radiation, embossing, extruding, and coextruding.

Typically, the sacrificial template layer can include a photocurable material that can have a low viscosity during the replication process and then can be quickly cured to form a permanent crosslinked polymeric network "locking in" the replicated nanostructures, microstructures or hierarchical structures. Useful photocurable resins include those which photopolymerize readily and decompose cleanly via pyrolysis or combustion. Additionally, the resins used for the template layer must be compatible with the application of an adhesion promotion layer as discussed above.

A photocurable material can generally be made from a polymerizable composition comprising polymers having molecular weights of about 1,000 or less (e.g., oligomers and macromonomers). Particularly suitable polymers have molecular weights of about 500 or less, and even more particularly suitable polymerizable polymers have molecular weights of about 200 or less. Said polymerizable compositions are typically cured using actinic radiation, e.g., visible light, ultraviolet radiation, electron beam radiation, heat and combinations thereof, or any of a variety of conventional anionic, cationic, free radical or other polymerization techniques, which can be photochemically or thermally initiated.

The polymerizable composition used to prepare the template layer may be monofunctional or multifunctional (e.g., di-, tri-, and tetra-) in terms of radiation curable moieties.

The polymerization reactions generally lead to the formation of a three-dimensional "crosslinked" macromolecular network and are also known in the art as negative-tone photoresists, as reviewed by Shaw et al., "Negative photoresists for optical lithography," IBM Journal of Research and Development (1997) 41, 81-94. The formation of the network may occur through either covalent, ionic, or hydrogen bonding, or through physical crosslinking mechanisms such as chain entanglement. The reactions can also be initiated through one or more intermediate species, such as free-radical generating photoinitiators, photosensitizers, photoacid generators, photobase generators, or thermal acid generators. The type of curing agent used depends on the polymerizable precursor used and on the wavelength of the radiation used to cure the polymerizable precursor. Examples of suitable commercially available free-radical generating photoinitiators include benzophenone, benzoin ether, and acylphosphine photoinitiators, such as those sold under the trade designations "IRGACURE" and "DAROCUR" from Ciba Specialty Chemicals, Tarrytown, NY. Other exemplary photoinitiators include benzophenone, 2,2-dimethoxy-2-phenylacetophenone (DMPAP), 2,2-dimethoxyacetophenone (DMAP), xanthone, and thioxanthone.

Co-initiators and amine synergists may also be included to improve curing rates. Suitable concentrations of the curing agent in the crosslinking matrix range from about 1% by weight (wt%) to about 10 wt%, with particularly suitable concentrations ranging from about 1 wt% by to about 5 wt%, based on the entire weight of the polymerizable precursor. The polymerizable precursor may also include optional additives, such as heat stabilizers, ultraviolet light stabilizers, free-radical scavengers, and combinations thereof.

The disclosed transfer films can be made using a coating process as described, for example, in U.S. Pat. No. 4,766,023 (Lu et al). In this process, a transparent electrode is coated with a similar acrylic monomer composition to that described in Example 4 in U. S. Pat. No. 8,213,082 (Gaides et al.). The composition is polymerized with high intensity UV radiation while pressed against a cylindrical copper tool embossed with a microstructured pattern which is inverse to the desired microstructured pattern. The cured composition in the form of a microstructured layer can be released from the tool. Release can be facilitated by use of a release agent coated on the surface of the copper tool which produces a low surface energy surface. Suitable release agents may include polytetrafluoroethylene (PTFE) or other semi-fluorinated coatings, silicone coatings, and the like. The release agents may be applied by either solution or vapor-phase treatment of the metal tool. Release can also be facilitated by suitable design of the channels as described, for example, in U. S. Pat. No. 6,398,370 (Chiu et al.) wherein the channel walls are angled at a few degrees relative to the surface normal. The particular combination of monomers used to form the cured polymeric layer may be selected such that the modulus of the layer is low enough to enable release from the tool, but with enough cohesive strength not to break during roll to roll processing. If the cured polymeric layer is too soft, it will cohesively fail, but if it is too brittle, it will fracture or not pull out of the tool. The combination of monomers may be selected such that the cured polymeric layer sufficiently adheres to the substrate on which it is formed.

Patterned structured template layers can be formed by depositing a layer of a radiation curable composition onto one surface of a radiation transmissive carrier to provide a layer having an exposed surface, contacting a master with a preformed surface bearing a pattern capable of imparting a three-dimensional microstructure of precisely shaped and located interactive functional discontinuities including distal surface portions and adjacent depressed surface portions into the exposed surface of the layer of radiation curable composition on said carrier under sufficient contact pressure to impart said pattern into said layer, exposing said curable composition to a sufficient level of radiation through the carrier to cure said composition while the layer of radiation curable composition is in contact with the patterned surface of the master. This cast and cure process can be done in a continuous manner using a roll of carrier, depositing a layer of curable material onto the carrier, laminating the curable material against a master and curing the curable material using actinic radiation. The resulting roll of carrier with a patterned, structured template disposed thereon can then be rolled up. This method is disclosed, for example, in U. S. Pat. No. 6,858,253 (Williams et al.).

For extrusion or embossed template layers, the materials making up the template layer can be selected depending on the particular topography of the top structured surface that is to be imparted. In general, the materials are selected such that the structure is fully replicated before the materials solidify. This will depend in part on the temperature at which the material is held during the extrusion process and the temperature of the tool used to impart the top structured surface, as well as on the speed at which extrusion is being carried out. Typically, the extrudable polymer used in the top layer has a $T_g$ of less than about 140°C, or a $T_g$ of from about 85°C to about 120°C, in order to be amenable to extrusion replication and embossing under most operating conditions. In some embodiments, the carrier film and the template layer can be coextruded at the same time. This embodiment requires at least two layers of coextrusion-a top layer with one polymer and a bottom layer with another polymer. If the top layer comprises a first extrudable polymer, then the first extrudable polymer can have a $T_g$ of less than about 140°C or a $T_g$ of from about 85°C to about 120°C. If the top layer comprises a second extrudable polymer, then the second extrudable polymer, which can function as the carrier layer, has a $T_g$ of less than about 140°C or a $T_g$ of from about 85°C to about 120°C. Other properties such as molecular weight and melt viscosity should also be considered and will depend upon the particular polymer or polymers used. The materials used in the template layer should also be selected so that they provide good adhesion to the carrier so that delamination of the two layers is minimized during the lifetime of the optical article.

The extruded or coextruded template layer can be cast onto a master roll that can impart patterned structure to the template layer. This can be done batchwise or in a continuous roll-to-roll process

The template layer comprises sacrificial material meaning that the sacrificial component of the template layer will be removed from the construction at a later time as is the template layer disclosed in Applicants' pending application No. 2014/0021492, entitled "STRUCTURED LAMINATION TRANSFER FILMS AND METHODS", filed July 20, 2012.

Sacrificial Materials

The sacrificial material comprises at least a binder precursor selected from polysilazanes or metal alkoxide. Sacrificial materials can include an organic component, such as a polymer and/or binder.

The organic component of either sacrificial layer is capable of being pyrolyzed, combusted, or otherwise substantially removed while leaving any adjacent layer, including structured surfaces, substantially intact. The adjacent layer can include, for example, a backfill layer having a structured surface or two layers having a structured surface between them. In the present disclosure, the support substrate, the template layer, or both can be sacrificial layers. The sacrificial layer can have a structured surface.

In some embodiments, inorganic nanomaterials may be dispersed in the sacrificial support film, the sacrificial template layer or both. These sacrificial layers comprise a sacrificial materials component (e.g. a sacrificial polymer such as PMMA) and may further comprise a thermally stable materials component (e.g. an inorganic nanomaterial, an inorganic binder, or thermally stable polymer). Bake-out of the laminate article involves the decomposition of sacrificial material in the sacrificial film or layer(s) while leaving the thermally stable materials component(s) substantially intact. The sacrificial materials component of sacrificial template or the sacrificial support substrate composition may vary from 1 to 99.9 wt% of the total solids of the formulation, or preferably from 40 to 99 wt% by weight of the total solids of the formulation.

The inorganic nanomaterials can be functionalized so that they are compatible with the organic sacrificial material. For example, if (meth)acrylic polymers are present in the sacrificial materials, the inorganic nanomaterials can be functionalized with an (meth)acrylate-containing functional molecule that interacts with the inorganic nanomaterials and with the sacrificial material. Useful compatibilizing groups for inorganic nanomaterials dispersed in acrylates include hydroxyl ethyl acrylic succinic acid, methoxyethoxyacetic acid (MEEAA) and acrylopropyl trimethoxysilane (AILQUEST A-174 Silane, available from OSI Specialties, Middlebury, CT). Other high refractive index inorganic oxide nanoparticles that include surface treatment for incorporation into a polymerizable resin are disclosed, for example, in U. S. Pat. Appl. Publ. No. 2012/0329959 A1 (Jones et al.). The disclosed surface treatment includes compounds comprising a carboxylic acid end group and a $C_3$-$C_8$ ester repeat unit.

The structured surface of the sacrificial layer can be formed through embossing, a replication process, extrusion, casting, or surface structuring, for example. The structured surface can include nanostructures, microstructures, or hierarchical structures. Nanostructures comprise features having at least one dimension (e.g., height, width, or length) less than or equal to two microns. Microstructures comprise features having at least one dimension (e.g., height, width, or length) less than or equal to one millimeter. Hierarchical structures are combinations of two sizes of structures, for example, nanostructures and microstructures.

Materials that may be used for the sacrificial layer (sacrificial support layer or sacrificial template layer) include, polyvinyl alcohol (PVA), ethylcellulose, methylcellulose, polynorbornes, poly(methylmethacrylate (PMMA), poly(vinylbutyral), poly(cyclohexene carbonate), poly(cyclohexene propylene) carbonate, poly(ethylene carbonate) poly(propylene carbonate) and other aliphatic polycarbonates, and other materials described in chapter 2, section 2.4 "Binders" of R.E. Mistler, E.R. Twiname, Tape Casting: Theory and Practice, American Ceramic Society, 2000. There are many commercial sources for these materials, a few of which are included in Table 1 below. These materials are typically easy to remove via dissolution or thermal decomposition via pyrolysis or combustion. Thermal heating is typically part of many manufacturing processes and thus removal of the sacrificial material may be accomplished during an existing heating step.

For this reason, thermal decomposition via pyrolysis or combustion is a more preferred method of removal. Sacrificial material should be capable of being coated onto a carrier or support substrate via extrusion, knife coating, solvent coating, cast and cure, or other typical coating methods. These methods are described above.

The decomposition temperature of the sacrificial material should be above the curing temperature of the backfill material(s). Once the backfill material is cured, the structure is permanently formed and the sacrificial template layer can be removed via any one of the methods listed above. Materials that thermally decompose with low ash or low total residue at the bakeout temperature are preferred over those that have higher residuals. Residue left behind on a substrate may adversely impact optical properties such as the transparency or color of the final product. Since it is desirable to minimizing any changes to these properties in the final product, residual levels of less than 1000 ppm at the bake-out temperature are preferred. Residuals levels of less than 500 ppm at the bake-out temperature are more preferred and residual level below 50 ppm at the bake-out temperature are most preferred. The sacrificial component(s) of the sacrificial layer(s) can be removed by pyrolysis or combustion without leaving a substantial amount of residual material such as ash at the bake-out temperature. Examples of preferred residual levels are provided above, although different residual levels can be used depending upon a particular application. It is also important that the decomposition of the sacrificial materials should be at a bake-out temperature that does not significantly change the physical properties of the receptor substrate.

Table 1

| Sacrificial Materials | | |
|---|---|---|
| Material Name or Trade Designation | Type | Available from |
| ETHOCEL | Ethylcellulose | Dow Chemical (Midland, MI) |
| FIBERLEASE P.V.A | Polyvinyl alcohol | Fiberlay Inc (Seattle, WA) |
| PARTALL Film #10 | Polyvinyl alcohol | Rexco (Conyers, GA) |
| ASR Series | Polynorbornenes | Promerus (Cleveland, OH) |
| NOVOMER PPC | Polypropylene carbonate | Novomer Inc (Ithaca, NY) |
| QPAC Series | Aliphatic polycarbonates | Empower Materials (New Castle, DE) |
| PDM 1086 | Polynorbornene | Promerus (Cleveland, OH) |
| PVA-236 | Polyvinyl alcohol | Kuraray America Inc. (Houston, TX) |

Release Layer

The support substrate can have a releasable surface. Reduction of the adhesion of the support substrate to any layer applied to it can be accomplished by application of a release coating to the support substrate. One method of applying a release coating to the surface of the support substrate is with plasma deposition. An oligomer can be used to create a plasma cross-linked release coating. The oligomer may be in liquid or in solid form prior to coating. Typically the oligomer has a molecular weight greater than 1000. Also, the oligomer typically has a molecular weight less than 10,000 so that the oligomer is not too volatile. An oligomer with a molecular weight greater than 10,000 typically may be too non-volatile, causing droplets to form during coating. In one embodiment, the oligomer has a molecular weight greater than 3000 and less than 7000. In another embodiment, the oligomer has a molecular weight greater than 3500 and less than 5500. Typically, the oligomer has the properties of providing a low-friction surface coating. Suitable oligomers include silicone-containing hydrocarbons, reactive silicone containing trialkoxysilanes, aromatic and aliphatic hydrocarbons, fluorochemicals and combinations thereof. For example, suitable resins include, but are not limited to, dimethylsilicone, hydrocarbon based polyether, fluorochemical polyether, ethylene teterafluoroethylene, and fluorosilicones. Fluorosilane surface chemistry, vacuum deposition, and surface fluorination may also be used to provide a release coating.

Plasma polymerized thin films constitute a separate class of material from conventional polymers. In plasma polymers, the polymerization is random, the degree of cross-linking is extremely high, and the resulting polymer film is very different from the corresponding "conventional" polymer film. Thus, plasma polymers are considered by those skilled in the art to be a uniquely different class of materials and are useful in the disclosed articles. In addition, there are other ways to apply release coatings to the template layer, including, but not limited to, blooming, coating, coextrusion, spray coating, electrocoating, or dip coating.

Inorganic Nanomaterials

Inorganic nanomaterials include zero-, one-, two-, and three dimensional inorganic materials comprising particles, rods, sheets, spheres, tubes, wires, cubes, cones, tetrahedrons, or other shapes which have one or more external dimensions in the size range of 1 nm to 1000 nm. An exemplary list of nanomaterials can be found in "Nanomaterials Chemistry, C. N. R. Rao (Editor), Achim Müller (Editor), Anthony K. Cheetham (Editor), Wiley-VCH, 2007.

The amount of the nanomaterial included in the sacrificial template or the sacrificial support substrate composition may vary from 0.1 to 99 wt% of the total solids of the formulation, or preferably from 1 to 60 wt% by weight of the total solids of the formulation.

The sacrificial template compositions or sacrificial support substrate compositions described herein may comprise inorganic nanomaterials. The inorganic nanomaterials may include allotropes of carbon, such as diamond, carbon nanotubes (single or multi-wall), carbon nanofibers, nanofoams, fullerenes (buckyballs, buckytubes and nanobuds) graphene, graphite, and the like.

The sacrificial template compositions described herein preferably comprise inorganic particles. These particles can be of various sizes and shapes. The nanoparticles can have an average particle diameter less than about 1000 nm, less than about 100 nm, less than about 50 nm, less than 10, to about 1 nm. The nanoparticles can have an average particle diameter from about 1 nm to about 50 nm, or from about 3 nm to about 35 nm, or from about 5 to about 25 nm. If the nanoparticles are aggregated, the maximum cross sectional dimension of the aggregated particle can be within any of these ranges, and can also be greater than about 100 nm. "Fumed" nanoparticles, such as silica and alumina, with primary size less than about 50 nm, may also be used, such as CAB-OSPERSE PG 002 fumed silica, CAB-O-SPERSE 2017A fumed silica, and CAB-OSPERSE PG 003 fumed alumina, available from Cabot Co. Boston, MA. Their measurements can be based on transmission electron microscopy (TEM). Nanoparticles can be substantially fully condensed. Fully condensed nanoparticles, such as the colloidal silica, typically have substantially no hydroxyls in their interiors. Non-silica containing fully condensed nanoparticles typically have a degree of crystallinity (measured as isolated particles) greater than 55%, preferably greater than 60%, and more preferably greater than 70%. For example, the degree of crystallinity can range up to about 86% or greater. The degree of crystallinity can be determined by X-ray diffraction techniques. Condensed crystalline (e.g. zirconia) nanoparticles have a high refractive index whereas amorphous nanoparticles typically have a lower refractive index.

The inorganic nanomaterial selected can impart various optical properties (i.e. refractive index, birefringence), electrical properties (e.g. conductivity), mechanical properties (e.g. toughness, pencil hardness, scratch resistance increase) or a combination of these properties. The size is generally chosen to avoid significant visible light scattering in the final article. It may be desirable to use a mix of inorganic nanomaterial types to optimize an optical or material property and to lower total composition cost.

Examples of suitable inorganic nanomaterials include metal nanomaterials or their respective oxides, including the elements zirconium (Zr), titanium (Ti), hafnium (Hf), aluminum (Al), iron (Fe), vanadium (V), antimony (Sb), tin (Sn), gold (Au), copper (Cu), gallium (Ga), indium (In), chromium (Cr), manganese (Mn), cobalt (Co), nickel (Ni), zinc (Zn), yttrium (Y), niobium (Nb), molybdenum (Mo), technetium (Te), ruthenium (Ru), rhodium (Rh), palladium (Pd), silver (Ag), cadmium (Cd), lanthanum (La), tantalum (Ta), tungsten (W), rhenium (Rh), osmium (Os), iridium (Ir), platinum (Pt), and any combinations thereof.

In a preferred embodiment, nanomaterials of zirconium oxide (zirconia) are used. Zirconia nanoparticles can have a particle size from approximately 5 to 50 nm, or 5 to 15 nm, or 10 nm. Zirconia nanoparticles can be present in the durable article or optical element in an amount from 10 to 70 wt%, or 30 to 50 wt%. Zirconias for use in materials of the invention are commercially available from Nalco Chemical Co. (Naperville, Ill.) under the product designation NALCO OOSSOO8 and from Buhler AG Uzwil, 20 Switzerland under the trade designation "Buhler zirconia Z-WO sol". Zirconia nanoparticle can also be prepared such as described in U.S. Pat. No. 7,241,437 (Davidson et al.) and U. S. Pat No. 6,376,590 (Kolb et al.). Titania, antimony oxides, alumina, tin oxides, and/or mixed metal oxide nanoparticles can be present in the durable article or optical element in an amount from 10 wt% to 70 wt%, or 30 wt% to 50 wt%. Mixed metal oxide for use in materials of the invention are commercially available from Catalysts & Chemical Industries Corp., (Kawasaki, Japan) under the product designation Optolake.

Other examples of suitable inorganic nanoparticles include elements and alloys known as semiconductors and their respective oxides such as silicon (Si), germanium (Ge), silicon carbide (SiC), silicon germanide (SiGe), aluminium nitride (AlN), aluminium phosphide (AlP), boron nitride (BN), gallium antimonide (GaSb), indium phosphide (InP), gallium arsenide nitride (GaAsN), gallium arsenide phosphide (GaAsP), indium aluminum arsenide nitride (InAlAsN), zinc oxide (ZnO), zinc selenide (ZnSe), zinc sulfide (ZnS), zinc telluride (ZnTe), mercury zinc selenide (HgZnSe), lead sulfide (PbS), lead telluride (PbTe), tin sulfide (SnS), lead tin telluride (PbSnTe), thallium tin telluride ($Tl_2SnTe_5$), zinc phosphide ($Zn_3P_2$), zinc arsenide ($Zn_3As_2$), zinc antimonide ($Zn_3Sb_2$), lead(II) iodide ($PbI_2$), copper(I) oxide ($Cu_2O$).

Silicon dioxide (silica) nanoparticles can have a particle size from 5 to 75 nm or 10 to 30 nm or 20 nm. Suitable silicas are commercially available from Nalco Chemical Co. (Naperville, Ill.) under the trade designation NALCO COLLOIDAL SILICAS. For example, silicas 10 include NALCO trade designations 1040, 1042, 1050, 1060, 2327 and 2329. the organosilica under the product name IPA-ST-MS, IPA-ST-L, IPA-ST, IPA-ST-UP, MA-ST-M, and MAST sols from Nissan Chemical America Co. Houston, TX and the SNOWTEX ST-40, ST-50, ST-20L, ST-C, ST-N, ST-O, ST-OL, ST-ZL, ST-UP, and ST-OUP, also from Nissan Chemical America Co. Houston, TX. Suitable fumed silicas include for example, products sold under the tradename, AEROSIL series OX-50, -130, -150, and -200 available from DeGussa AG, (Hanau, Germany), and CAB-O-SPERSE 2095, CAB-O-SPERSE A105, CAB-O-SIL M5 available from Cabot Corp. (Tuscola, 111.). The preferred ranges of weight percent of nanoparticles range from about 1 wt% to about 60 wt%, and can depend on the density and size of the nanoparticle used.

Within the class of semiconductors include nanoparticles known as "quantum dots," which have interesting electronic and optical properties that can be used in a range of applications. Quantum dots can be produced from binary alloys such as cadmium selenide, cadmium sulfide, indium arsenide, and indium phosphide, or from ternary alloys such as cadmium selenide sulfide, and the like. Companies that sell quantum dots include Nanoco Technologies (Manchester, UK) and Nanosys (Palo Alto, CA).

Examples of suitable inorganic nanoparticles include elements known as rare earth elements and their oxides, such as lanthanum (La), cerium ($CeO_2$), praseodymium ($Pr_6O_{11}$), neodymium ($Nd_2O_3$), samarium ($Sm_2O_3$), europium ($Eu_2O_3$), gadolinium ($Gd_2O_3$), terbium ($Tb_4O_7$), dysprosium ($Dy_2O_3$), holmium ($Ho_2O_3$), erbium ($Er_2O_3$), thulium ($Tm_2O_3$), ytterbium ($Yb_2O_3$) and lutetium ($Lu_2O_3$).

The nanoparticles are typically treated with a surface treatment agent. Surface-treating the nano-sized particles can provide a stable dispersion in the polymeric resin. Preferably, the surface-treatment stabilizes the nanoparticles so that the particles will be well dispersed in the sacrificial template resin and result in a substantially homogeneous composition. Furthermore, the nanoparticles can be modified over at least a portion of its surface with a surface treatment agent so that the stabilized particle can copolymerize or react with the polymerizable resin during curing. In general, a surface treatment agent has a first end that will attach to the particle surface (covalently, ionically or through strong physisorption) and a second end that imparts compatibility of the particle with the resin and/or reacts with resin during curing. Examples of surface treatment agents include alcohols, amines, carboxylic acids, sulfonic acids, phospohonic acids, silanes and titanates. The preferred type of treatment agent is determined, in part, by the chemical nature of the metal oxide surface. Silanes are preferred for silica and other for siliceous fillers. Silanes and carboxylic acids are preferred for metal oxides such as zirconia. The surface modification can be done either subsequent to mixing with the monomers or after mixing. It is preferred in the case of silanes to react the silanes with the particle or nanoparticle surface before incorporation into the resin. The required amount of surface modifier is dependent upon several factors such particle size, particle type, modifier molecular weight, and modifier type. In general it is preferred that approximately a monolayer of modifier is attached to the surface of the particle. The attachment procedure or reaction conditions required also depend on the surface modifier used. For silanes, it is preferred to surface treat at elevated temperatures under acidic or basic conditions for from 1-24 hr approximately. Surface treatment agents such as carboxylic acids may not require elevated temperatures or extended time.

Representative embodiments of surface treatment agents suitable for the compositions include compounds such as, for example, isooctyl trimethoxy-silane, N-(3- triethoxysilylpropyl) methoxyethoxyethyl carbamate ($PEG_3TES$), N-(3-triethoxysilylpropyl) methoxyethoxyethyl carbamate ($PEG_2TES$), 3- (methacryloyloxy)propyltrimethoxysilane, 3-acryloxypropyltrimethoxysilane, 3 -(methacryloyloxy)propyltriethoxysilane, 3 -(methacryloyloxy) propylmethyldimethoxysilane, 3 -(acryloyloxypropyl)methyldimethoxysilane, 3-(methacryloyloxy)propyldimethylethoxysilane, 3 -(methacryloyloxy) propyldimethylethoxysilane, vinyldimethylethoxysilane, phenyltrimethoxysilane, n-octyltrimethoxysilane, dodecyltrimethoxysilane, octadecyltrimethoxysilane, propyltrimethoxysilane, hexyltrimethoxysilane, vinylmethyldiacetoxysilane, vinylmethyldiethoxysilane, vinyltriacetoxysilane, vinyltriethoxysilane, vinyltriisopropoxysilane, vinyltrimethoxysilane, vinyltriphenoxysilane, vinyltri-t-butoxysilane, vinyltris-isobutoxysilane, vinyltriisopropenoxysilane, vinyltris(2-methoxyethoxy) silane, styrylethyltrimethoxysilane, mercaptopropyltrimethoxysilane, 3-5 glycidoxypropyltrimethoxysilane, acrylic acid, methacrylic acid, oleic acid, stearic acid, dodecanoic acid, 2-[2-(2-methoxyethoxy)ethoxy] acetic acid (MEEAA), beta-carboxyethylacrylate, 2-(2-methoxyethoxy)acetic acid, methoxyphenyl acetic acid, and mixtures thereof. Further, a proprietary silane surface modifier, commercially available from OSI Specialties, Crompton South Charleston, WV under the trade designation "Silquest A1230", has been found particularly suitable.

The surface modification of the particles in the colloidal dispersion can be accomplished in a variety of ways. The process involves the mixture of an inorganic dispersion with surface modifying agents. Optionally, a co-solvent can be added at this point, such as for example, 1-methoxy-2-propanol, ethanol, isopropanol, ethylene glycol, 15 N,N-dimethylacetamide and 1-methyl-2-pyrrolidinone. The co-solvent can enhance the solubility of the surface modifying agents as well as the surface modified particles. The mixture comprising the inorganic sol and surface modifying agents is subsequently reacted at room or an elevated temperature, with or without mixing. In one method, the mixture can be reacted at about 85°C for about 24 hours, resulting in the surface modified sol. In another method, where metal oxides are surface modified the surface treatment of the metal oxide can preferably involve the adsorption of acidic molecules to the particle surface. The surface modification of the heavy metal oxide preferably takes place at room temperature.

The surface modification of $ZrO_2$ with silanes can be accomplished under acidic conditions or basic conditions. In one case the silanes are heated under acid conditions for a suitable period of time. At which time the dispersion is combined with aqueous ammonia (or other base). This method allows removal of the acid counter ion from the $ZrO_2$ surface as well as reaction with the silane. In one method the particles are precipitated from the dispersion and separated from the liquid component.

A preferred combination of surface modifying agents includes at least one surface modifying agent having a functional group that is co-polymerizable with the (organic component of the) sacrificial template resin and a second modifying agent different than the first modifying agent. The second modifying agent is optionally co-polymerizable with the organic component of the polymerizable composition. The second modifying agent may have a low refractive index (i.e. less than 1.52 or less than 1.50). The second modifying agent is preferably a poly(alkyleneoxide)-containing modifying agent that is optionally co-polymerizable with the organic component of the polymerizable composition.

The surface modified particles can then be incorporated into the sacrificial template resin in various methods. In a preferred aspect, a solvent exchange procedure is utilized whereby the resin is added to the surface modified sol, followed by removal of the water and co-solvent (if used) via evaporation, thus leaving the particles dispersed in the sacrificial template resin. The evaporation step can be accomplished for example, via distillation, rotary evaporation, or oven drying. In another aspect, the surface modified particles can be extracted into a water 20 immiscible solvent followed by solvent exchange, if so desired. Alternatively, another method for incorporating the surface modified nanoparticles in the polymerizable resin involves the drying of the modified particles into a powder, followed by the addition of the resin material into which the particles are dispersed. The drying step in this method can be accomplished by conventional means suitable for the system, such as, for example, oven drying or spray drying.

Metal oxide precursors may be used in order to act as an amorphous "binder" for the inorganic nanoparticles, or they may be used alone. Suitable concentrations of the metal oxide precursors relative to the inorganic nanoparticle may range from 0.1 to 99.9 wt% of the total solids of the sacrificial template/ nanomaterial system. Preferably, between 1 and 25% wt% of the system is composed of metal oxide precursor material. Sol-gel techniques may be used to react these precursors in order to cure the material into a solid mass and are known to those skilled in the art. The hydrolysis and condensation steps of the sol-gel reaction may be performed before addition of the metal oxide precursor into the sacrificial resin composition, or they may be performed after incorporation into the sacrificial resin composition at ambient temperature. Additional hydrolysis and condensation steps may also occur after mixing into the sacrificial resin composition (sacrificial material) during the bake-out cycle of the sacrificial template. In other words, as the sacrificial resin is removed, the metal-oxide precursor may be undergoing hydrolysis and condensation mechanisms. Suitable metal oxide precursors include alkyl titanates such as titanium (IV) butoxide, n-propyl titanate, titanium triethanolamine, titanium phosphate glycol, 2-ethylhexyl titanate, titanium (IV) ethoxide, titanium (IV) isopropoxide, and the like. These are commercially available under the "TYZOR" trade name owned by Dorf-Ketal Inc. (Houston, TX). Also suitable metal oxide precursors include zirconium chloride or zirconium(IV) alkoxides such as zirconium (IV) acrylate, zirconium(IV) tetraisopropoxide, zirconium(IV) tetraethoxide, zirconium(IV) tetrabutoxide, and the like, all available from Aldrich (St. Louis, MO). Also suitable metal oxide precursors include hafnium(IV) chloride or hafnium alkoxides such as hafnium(IV) carboxyethyl acrylate, hafnium(IV) tetraisopropoxide, hafnium(IV) tert-butoxide, hafnium(IV) n-butoxide, also available from Aldrich (St. Louis, MO).

Thermally Stable Backfill and Planarization Materials

The backfill layer is a material capable of at least partially filling a structured surface in a template layer to which it is applied. The backfill layer can alternatively be a bilayer of two different materials where the bilayer has a layered structure. The two materials for the bilayer can optionally have different indices of refraction. One of the bilayers can optionally comprise an adhesion promoting layer.

Substantial planarization means that the amount of planarization (P%), as defined by Equation (1), is preferably greater than 50%, more preferably greater than 75%, and most preferably greater than 90%.

$$P\% = (1 - (t_1/h_1)) * 100$$

Equation (1)

where t, is the relief height of a surface layer and $h_1$ is the feature height of features covered by the surface layer, as further disclosed in P. Chiniwalla, IEEE Trans. Adv. Packaging 24(1), 2001, 41.

Materials that may be used for the backfill include polysiloxane resins, polysilazanes, polyimides, silsesquioxanes of bridge or ladder-type, silicones, and silicone hybrid materials and many others. Exemplary polysiloxane resins include PERMANEW 6000 L510-1, available from California Hardcoat, Chula Vista, CA. These molecules typically have an inorganic core which leads to high dimensional stability, mechanical strength, and chemical resistance, and an organic shell that helps with solubility and reactivity. There are many commercial sources of these materials, which are summarized in Table 2 below. Other classes of materials that may be of use are benzocyclobutenes, soluble polyimides, and polysilazane resins, for example.

Table 2

| Thermally Stable Backfill Materials of Low and High Refractive Index | | |
|---|---|---|
| Material Name or Trade Designation | Type | Available from |
| TecheGlas GRx resins | T-resin (methyl silsesquioxane) | TechneGlas (Perrysburg, Ohio) |
| HSG-510 | T-resin (methyl silsesquioxane) | Hitachi Chemical (Tokyo, Japan) |
| ACCUGLASS 211 | T-Q resin (methyl silsesquioxane) | Honeywell (Tempe, AZ) |
| HARDSIL AM | silica nanocomposite | Gelest Inc (Morrisville, PA) |
| MTMS-BTSE Copolymer (Ro et. al, Adv. Mater. 2007, 19, 705-710) | bridged silsesquioxane | National Institute of Standards and Technology (Gaithersburg, MD) |
| PERMANEW 6000 | silica-filled methylpolysiloxane polymer containing a latent heat-cure catalyst system | California Hardcoat (Chula Vista, CA) |
| FOX Flowable Oxide | hydrogen silsesquioxane | Dow Corning (Midland, MI) |
| ORMOCER, ORMOCLAD, ORMOCORE | silicone hybrid | Micro Resist GmBH (Berlin, Germany) |
| SILECS SCx resins | silicone hybrid (n = 1.85) | Silecs Oy (Espoo, Finland) |
| OPTINDEX D1 | soluble polyimide (n=1.8) | Brewer Science (Rolla, MO) |
| CORIN XLS resins | soluble polyimide | NeXolve Corp. (Huntsville, AL) |
| CERASET resins | polysilazanes | KiON Specialty Polymers (Charlotte, NC) |
| BOLTON metals | low melting metal | Bolton Metal Products (Bellafonte, PA) |
| CYCLOTENE resins | benzocyclobutane polymers | Dow Chemical (Midland, MI) |
| SYLGARD 184 | silicone network polymer | Dow Corning (Midland, MI) |
| OPTINDEX A54 | Metal-oxide precursor capped with organic ligands | Brewer Science (Rolla, MO) |
| NAT-311K | Titania Nanoparticles dispersed in Methyl Ethyl Ketone | Nagase ChemTex (Tokyo, Japan) |

Other materials useful for the backfill layer can include vinyl silsequioxanes; sol gel materials; silsesquioxanes; nanoparticle composites including those that include nanowires; quantum dots; nanorods; abrasives; metal nanoparticles; sinterable metal powders; carbon composites comprising graphene, carbon nanotubes, and fullerenes; conductive composites; inherently conductive (conjugated) polymers; electrically active materials (anodic, cathodic, etc.); composites comprising catalysts; low surface energy materials; and fluorinated polymers or composites. These materials can also be used as inorganic nanomaterials in the sacrificial support substrate or the sacrificial template layer.

The backfill layer can comprise any material as long as it has the desired rheological and physical properties discussed previously. The backfill layer may be made from a polymerizable composition comprising monomers which are cured using actinic radiation, e.g., visible light, ultraviolet radiation, electron beam radiation, heat and combinations thereof. Any of a variety of polymerization techniques, such as anionic, cationic, free radical, condensation or others may be used, and these reactions may be catalyzed using photo, photochemical or thermal initiation. These initiation strategies may impose thickness restrictions on the backfill layer, i.e. the photo or thermal trigger must be able to uniformly react throughout the entire film volume.

The present disclosure presents articles and methods for forming embedded nanostructures having various optical properties, such as high refractive index in the constructions. The various embodiments presented herein have support substrates or template layers that include inorganic nanomaterials. In some embodiments, the inorganic nanomaterials include titanates, silicates, or zirconates. The support substrate, the template layer, or both can contain inorganic nanomaterials. Typically, the inorganic nanomaterials are contained in a sacrificial binder or polymer that is used to construct the disclosed structures. In some embodiments, two different layers in a construction of a transfer film can include two different sacrificial binders that have two different decomposition temperatures. These two different layers, for example a support substrate layer and a template layer, can contain two different types of inorganic nanomaterials that may end up forming densified layers of nanomaterials with two different optical properties. The different types of inorganic nanomaterials can be due to compositional differences or size differences, or both. In some embodiments, different layers in the disclosed articles can include chemically identical nanoparticles but with each layer segregated by nanoparticle size or size distribution. The inorganic nanoparticle-containing support substrates or template layers are capable of being cleanly pyrolyzed or combusted while leaving a densified layer of nanomaterials in their place.

Different varieties of the above materials can be synthesized with higher refractive index by incorporating nanoparticles or metal oxide precursors in with the polymer resin. Silecs SC850 material is a modified silsesquioxane ($n \approx 1.85$) and Brewer Science high index polyimide OptiNDEX D1 material ($n \approx 1.8$) are examples in this category. Other materials include a copolymer of methyltrimethoxysilane (MTMS) and bistriethoxysilylethane (BTSE) (Ro et. al, Adv. Mater. 2007, 19, 705-710). This synthesis forms readily soluble polymers with very small, bridged cyclic cages of silsesquioxane. This flexible structure leads to increased packing density and mechanical strength of the coating. The ratio of these copolymers can be tuned for very low coefficient of thermal expansion, low porosity and high modulus.

The backfill material, typically, can meet several requirements. First, it can adhere and conform to the structured surface of the template layer on which it is coated. This means that the viscosity of the coating solution should be low enough to be able to flow into very small features without the entrapment of air bubbles, which will lead to good fidelity of the replicated structure. If it is solvent based, it should be coated from a solvent that does not dissolve or swell the underlying template layer, which would cause cracking or swelling of the backfill. It is desirable that the solvent has a boiling point below that of the template layer glass transition temperature. Preferably, isopropanol, butyl alcohol and other alcoholic solvents have been used. Second, the material should cure with sufficient mechanical integrity (e.g., "green strength"). If the backfill material does not have enough green strength after curing, the backfill pattern features will slump and replication fidelity will degrade. Third, for some embodiments, the refractive index of the cured material should be tailored to produce the proper optical effect. Other substrates of a different refractive index can also be used for this process, such as sapphire, nitride, metal, or metal oxide. Fourth, the backfill material should be thermally stable (e.g., showing minimal cracking, blistering, or popping) above the maximum bake-out temperature. The materials used for this layer undergo a condensation curing step, which may cause undesirable shrinkage and the build-up of compressive stresses within the coating. There are a few materials strategies which are used to minimize the formation of these residual stresses which have been put to use in several commercial coatings which satisfy all of the above criteria.

It can be advantageous to adjust the refractive index of both the template and backfill layer. For example, in OLED light extraction applications, the nanostructure imparted by the lamination transfer film is located at a structured interface of the template and planarized backfill layer. The template layer has a first side at the structured interface and a second side coincident with an adjacent layer. The planarized backfill layer has a first side at the structured interface and a second side coincident with an adjacent layer. In this application, the refractive index of the template layer is index matched to the adjacent layer to the backfill layer opposite the structured interface. Nanoparticles can be used to adjust refractive index of the backfill and planarization layers. For example, in acrylic coatings, silica nanoparticles ($n \approx 1.42$) can be used to decrease refractive index, while zirconia nanoparticles ($n \approx 2.1$) can be used to increase the refractive index.

Adhesion Promoting Layer Materials

The adhesion promoting layer can be implemented with any material enhancing adhesion of the transfer film to the receptor substrate without substantially adversely affecting the performance of the transfer film. The exemplary materials for the backfill and planarization layers can also be used for the adhesion promoting layer. A typical material for the adhesion promoting layer is the CYCLOTENE resin identified in Table 2. Other useful adhesion promoting materials useful in the disclosed articles and methods include photoresists (positive and negative), self-assembled monolayers, silane coupling agents, and macromolecules. In some embodiments, silsesquioxanes can function as adhesion promoting layers. Other exemplary materials may include benzocyclobutanes, polyimides, polyamides, silicones, polysiloxanes, silicone hybrid polymers, (meth)acrylates, and other silanes or macromolecules functionalized with a wide variety of reactive groups such as epoxide, episulfide, vinyl, hydroxyl, allyloxy, (meth)acrylate, isocyanate, cyanoester, acetoxy, (meth)acrylamide, thiol, silanol, carboxylic acid, amino, vinyl ether, phenolic, aldehyde, alkyl halide, cinnamate, azide, aziridine, alkene, carbamates, imide, amide, alkyne, and any derivatives or combinations of these groups.

Release Liners

The backfill layer can, optionally, be covered with a temporary release liner. The release liner can protect the patterned structured backfill during handling and can be easily removed, when desired, for transfer of the structured backfill or part of the structured backfill to a receptor substrate. Exemplary liners useful for the disclosed patterned structured film are disclosed in PCT Pat. Appl. Publ. No. WO 2012/082536 (Baran et al.).

The liner may be flexible or rigid. Preferably, it is flexible. A suitable liner (preferably, a flexible liner) is typically at least 0.5 mil (12.6 $\mu$m) thick, and typically no more than 20 mils (508 $\mu$m) thick. The liner may be a backing with a release coating disposed on its first surface. Optionally, a release coating can be disposed on its second surface. If this backing is used in a transfer article that is in the form of a roll, the second release coating has a lower release value than the first release coating. Suitable materials that can function as a rigid liner include metals, metal alloys, metal-matrix composites, metalized plastics, inorganic glasses and vitrified organic resins, formed ceramics, and polymer matrix reinforced composites.

Exemplary liner materials include paper and polymeric materials. For example, flexible backings include densified Kraft paper (such as those commercially available from Loparex North America, Willowbrook, IL), poly-coated paper such as polyethylene coated Kraft paper, and polymeric film. Suitable polymeric films include polyester, polycarbonate, polypropylene, polyethylene, cellulose, polyamide, polyimide, polysilicone, polytetrafluoroethylene, polyethylenephthalate, polyvinylchloride, polycarbonate, or combinations thereof. Nonwoven or woven liners may also be useful. Embodiments with a nonwoven or woven liner could incorporate a release coating. CLEARSIL T50 Release liner; silicone coated 2 mil (50 $\mu$m) polyester film liner, available from Solutia/CP Films, Martinsville, VA, and LOPAREX 5100 Release Liner, fluorosilicone-coated 2 mil (50 $\mu$m) polyester film liner available from Loparex, Hammond, WI, are examples of useful release liners.

The release coating of the liner may be a fluorine-containing material, a silicon-containing material, a fluoropolymer, a silicone polymer, or a poly(meth)acrylate ester derived from a monomer comprising an alkyl (meth)acrylate having an alkyl group with 12 to 30 carbon atoms. In one embodiment, the alkyl group can be branched. Illustrative examples of useful fluoropolymers and silicone polymers can be found in U. S. Pat. Nos. 4,472,480 (Olson), 4,567,073 and 4,614,667 (both Larson et al.). Illustrative examples of a useful poly(meth)acrylate ester can be found in U. S. Pat. Appl. Publ. No. 2005/118352 (Suwa). The removal of the liner shouldn't negatively alter the surface topology of the backfill layer.

Other Additives

Other suitable additives to include in the backfill, template, or adhesion promotion layer are antioxidants, stabilizers, antiozonants, and/or inhibitors to prevent premature curing during the process of storage, shipping and handling of the film. Antioxidants can prevent the formation of free radical species, which may lead to electron transfers and chain reactions such as polymerization. Antioxidants can be used to decompose such radicals. Suitable antioxidants may include, for example, antioxidants under the "IRGANOX" tradename. The molecular structures for antioxidants are typically hindered phenolic structures, such as 2,6-di-tert-butylphenol, 2,6-di-tert-butyl-4-methylphenol, or structures based on aromatic amines. Secondary antioxidants are also used to decompose hydroperoxide radicals, such as phosphites or phosphonites, organic sulphur containing compounds and dithiophosphonates. Typical polymerization inhibitors include quinone structures such hydroquinone, 2,5-di-tert-butyl-hydroquinone, monomethyl ether hydroquinone or catechol derivatives such as 4-tert-butyl catechol. Any antioxidants, stabilizers, antiozonants and inhibitors used must be soluble in the backfill, template, and adhesion promotion layer.

In some embodiments, the transfer film can include polymeric materials that decompose at two different temperatures. For example, the backfill layer can include an inorganic particle-containing backfill material having a high decomposition temperature. The backfill material having a high decomposition temperature can be a polymeric material that can be thermally stable at temperatures at which another polymeric component of the laminate article (e.g. the sacrificial support film or the sacrificial template layer) is thermally unstable. Typically, organic backfill materials having a high decomposition temperature can be acrylate polymers that contain thermally stable organic pendant groups. Highly branched pendent groups containing adamantane, norbornane, or other multicyclic bridged organic pendent groups are useful for in template materials having a high decomposition temperature. For example, "ADAMANTATE" acrylates, available from Idemitsu Kosan Co., Ltd, Beijing, CHINA, can be used to make acrylic polymers with adamantane pendent groups. Adamantane-containing monomers or norbornane-containing monomers with various functional groups are also available which can allow for use of other adamantane-containing systems. Additional polymers that have a high decomposition temperature can include polyamides, polyimides, poly(ether ether ketones), polyetherimide (ULTE), polyphenyls, polybenzimidazoles, poly(benzoxazoles), polybisthiazoles, poly(quinoxalines), poly(benzoxazines) and the like.

The sacrificial support film and sacrificial template layer may comprise both thermally stable materials and sacrificial materials. Thermally stable materials may comprise thermally stable polymers that have a decomposition temperature substantially higher than that of the polymer used for the sacrificial template, such that the other components remain substantially intact after the bake-out of the sacrificial material used for the sacrificial template. Chemical groups containing but not limited to aromatic or alicyclic moieties, such as adamantane, norbornane, or other bridged multicyclics are useful for thermally stable polymers. These thermally stable polymers may or may not be crosslinked into the resin of the sacrificial template. One example of a thermally stable polymer that may crosslink into the network of the sacrificial template resin includes polymers sold under the trade name "ADAMANTATE", available from Idemitsu Kosan Co., Ltd, Beijing, CHINA. ADAMANTATE polymers are sold with various functionalities, such as acrylate, methacrylate and epoxy, which can be used to chemically crosslink into a suitable sacrificial resin system. Other polymers that have a high decomposition temperature and may also be chemically functionalized to be compatible within a sacrificial template system can include but are not limited to poly(amide)s, poly(imide)s, poly(ether ether ketones), poly(etherimide) (available under the trade name "ULTEM," available from SABIC Innovative Plastics, Pittsfield, MA), poly(phenyl)s, poly(benzimidazole)s, poly(benzoxazoles), poly(bisthiazole)s, poly(quinoxalines), poly(benzoxazines) and the like. Various molecular weights of said thermally stable polymers may be chosen in order to modify their solubility in the sacrificial template resin system, from less than 200 (oligomers) to greater than 100,000 (polymer). Preferably, a molecular weight range of 500 to 10,000 may be used.

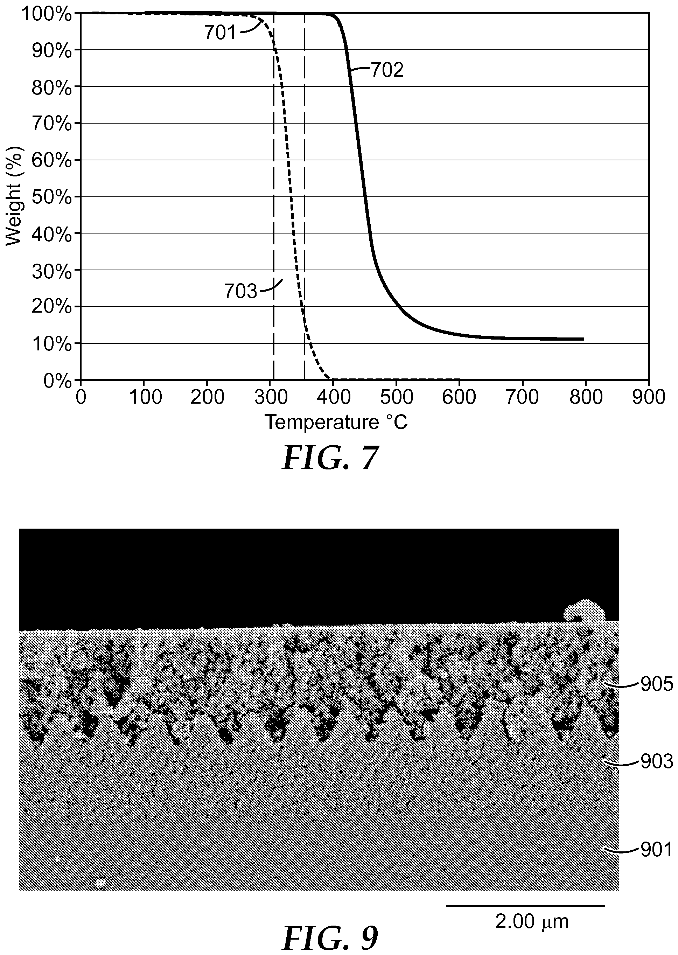

Fig. 7 is a graph of a thermal gravimetric analysis (TGA) of two polymers - a sacrificial polymer (PMMA) 701 and a polymer containing a crosslinked adamantane acrylate 702 that has a high decomposition temperature. Upon heating both materials, there is a temperature region (shown as region 703) from about 305°C to about 355°C where the PMMA significantly thermally degrades but the adamantane-containing acrylate (1,3-adamantanediol di(meth)acrylate, available from Idimitsu Kosan) is thermally stable. The temperature region 703 represents a process window for the use of both a polymeric sacrificial material and a polymeric thermally stable material in a single lamination transfer film. For example, one can be used as the thermally stable backfill material and one can be selectively pyrolyzed or otherwise decomposed as a sacrificial template material.

Receptor Substrates

Examples of receptor substrates include glass such as display mother glass, lighting mother glass, architectural glass, plate glass, roll glass, and flexible glass (can be used in roll to roll processes). An example of flexible roll glass is the WILLOW glass product from Corning Incorporated. Other examples of receptor substrates include metals such as metal sheets and foils. Yet other examples of receptor substrates include sapphire, silicon, silica, and silicon carbide. Yet another example includes fibers, nonwovens, fabric, and ceramics. Receptor substrates also may include, automotive glass, sheet glass, flexible electronic substrates such as circuitized flexible film, display backplanes, solar glass, flexible glass, metal, polymers, polymer composites, and fiberglass. Other exemplary receptor substrates include semiconductor materials on a support wafer.

The dimensions of receptor substrates can exceed those of a semiconductor wafer master template. Currently, the largest wafers in production have a diameter of 300 mm. Lamination transfer films produced using the method disclosed herein can be made with a lateral dimension of greater than 1000 mm and a roll length of hundreds of meters. In some embodiments, the receptor substrates can have dimensions of about 620 mm x about 750 mm, of about 680 mm x about 880 mm, of about 1100 mm x about 1300 mm, of about 1300 mm x about 1500 mm, of about 1500 mm x about 1850 mm, of about 1950 mm x about 2250 mm, or about 2200 mm x about 2500 mm, or even larger. For long roll lengths, the lateral dimensions can be greater than about 750 mm, greater than about 880 mm, greater than about 1300 mm, greater than about 1500 mm, greater than about 1850 mm, greater than about 2250 nm, or even greater than about 2500 mm. Typical dimensions have a maximum patterned width of about 1400 mm and a minimum width of about 300 mm. The large dimensions are possible by using a combination of roll-to-roll processing and a cylindrical master template. Films with these dimensions can be used to impart nanostructures over entire large digital displays (e.g., a 55 inch diagonal display, with dimensions of 52 inches wide by 31.4 inches tall) or large pieces of architectural glass.

The receptor substrate can optionally include a buffer layer on a side of the receptor substrate to which a lamination transfer film is applied. Examples of buffer layers are disclosed in U. S. Pat. No. 6,396,079 (Hayashi et al.), which is incorporated herein by reference as if fully set forth. One type of buffer layer is a thin layer of $SiO_2$, as disclosed in K. Kondoh et al., J. of Non-Crystalline Solids 178 (1994) 189-98 and T-K. Kim et al., Mat. Res. Soc. Symp. Proc. Vol. 448 (1997) 419-23.

A particular advantage of the transfer process disclosed herein is the ability to impart structure to receptor surfaces with large surfaces, such as display mother glass or architectural glass. The dimensions of these receptor substrates exceed those of a semiconductor wafer master template. The large dimensions of the lamination transfer films are possible by using a combination of roll-to-roll processing and a cylindrical master template. Roll-to-roll processing to make embedded nanostructures can include "cast and cure" of the template or backfill layer. An additional advantage of the transfer process disclosed herein is the ability to impart structure to receptor surfaces that are not planar. The receptor substrate can be curved, bent twisted, or have concave or convex features, due to the flexible format of the transfer film.

Applications of Lamination Transfer Films

The lamination transfer films disclosed herein can be used for a variety of purposes. For example, the lamination transfer films can be used to transfer structured layers in active matrix organic light-emitting diode (AMOLED) devices. In an example for OLED applications, a bilayer with embedded nanostructure comprising a glass-like nanostructured backfill layer and a high refractive index layer (from a densified layer of high index nanoparticles) can be disposed upon a glass substrate. The high refractive index layer be covered with a transparent conductive electrode material such as indium-tin oxide (ITO) or another high index layer. Another exemplary application of the lamination transfer films is for patterning of digital optical elements including microfresnel lenses, diffractive optical elements, holographic optical elements, and other digital optics disclosed in Chapter 2 of B.C. Kress, and P. Meyrueis, Applied Digital Optics, Wiley, 2009, on either the internal or external surfaces of display glass, photovoltaic glass elements, LED wafers, silicon wafers, sapphire wafers, architectural glass, metal, nonwovens, paper, or other substrates.

The lamination transfer films can also be used to produce decorative effects on glass surfaces. For example, it might be desirable to impart iridescence to the surface of a decorative crystal facet. In particular, the glass structures can be used in either functional or decorative applications such as transportation glasses, architectural glasses, glass tableware, artwork, display signage, and jewelry or other accessories. In some embodiments, decorative structure can be imparted onto a high index of refraction substrate such as high index glass. An exemplary structure of these embodiments can include a high index nanostructure (made from a densified structured layer of nanomaterials) disposed upon high index glass and planarized with a lower refractive index layer (e.g. from a densified layer of silica nanoparticles). Another construction can be a low index nanostructured layer on high index glass. Analogously, a high index nanostructured layer of can be disposed upon standard glass or alternatively a low index nanostructured layer can be disposed upon standard glass. In each case, the nanostructured surface is embedded within two layers of differing refractive index, enabling the optical phenomena described herein while protecting the nanostructure within a densified layer of nanomaterials. Hence, durability of the glass structures may be improved by using the methods disclosed herein to transfer embedded structures. Also, a coating can be applied over these glass structures. This optional coating can be relatively thin in order to avoid adversely affecting the glass structure properties. Examples of such coatings include hydrophilic coatings, hydrophobic coatings, protective coatings, anti-reflection coatings and the like.

Any of the disclosed transfer films can be laminated to a receptor substrate where the transfer film includes at least one of a sacrificial support layer or a sacrificial template layer. At least one of the sacrificial support layer or the sacrificial template layer can have a structured surface. At least one of the sacrificial support layer or the sacrificial template layer comprises inorganic nanomaterials and sacrificial materials. Then at least one of the sacrificial support layer or the sacrificial template layer can be densified. Densification can include any process that can produce a densified layer of nanomaterials having a high volume fraction of nanomaterials resulting from the pyrolysis or combustion of polymers containing inorganic materials such as nanoparticles. The densified layer of nanomaterials may comprise nanoparticles, partially-fused nanoparticles, chemically sintered nanoparticles, a fused glass-like material resulting from a sintering process, or a frit. It may further include residual non-particulate organic or inorganic materials that act as a sintering agent or binder.

A disclosed article can be produced by lamination of the disclosed transfer films to the receptor substrates and subjecting the laminates produced thereby to decomposition of the organic constituents via pyrolysis or combustion. The disclosed articles include the receptor substrate, a thermally stable backfill layer having a first surface and a second structured surface disposed upon the receptor and densified layer of inorganic nanomaterials such as nanoparticles disposed upon on the second structured surface of the thermally stable backfill layer. The first surface of the thermally stable backfill layer is in contact with the receptor substrate. A layer that includes densified layer of nanomaterials is disposed upon the second structured surface of the thermally stable backfill layer.

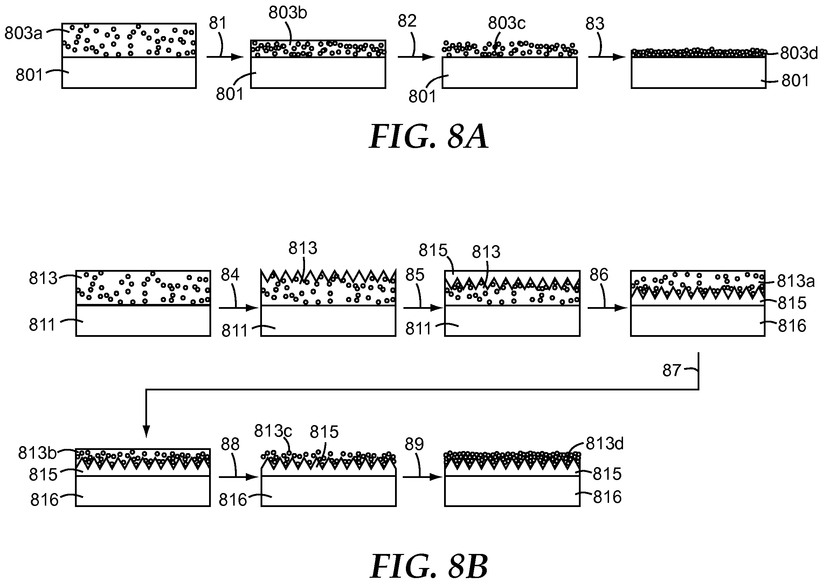

Fig. 8A is a general schematic diagram showing densification of a nanoparticle-containing sacrificial substrate layer with increasing time and/or temperature. The first substrate shows sacrificial layer 803a that includes inorganic nanomaterials and a polymer disposed upon receptor substrate 801. As heating is increased (time or temperature) sacrificial layer 803b disposed upon receptor substrate 801 is denser due to some thermal decomposition of the polymer. Further heating or time leads to the bake-out of substantially all of the organics leaving densified layer of nanomaterials 803c disposed upon receptor substrate 801. Finally, if enough heat or time is applied and/or if an inorganic binder is present, densified layer of nanomaterials 803c can at least partially fuse and further densify to form inorganic layer 803d. In some embodiments, the densified layer of nanomaterials can form a conductive film.

Fig. 8B is a schematic diagram showing the use of densification of a nanoparticle-containing sacrificial template layer to make an embodied article. Support substrate 811 has disposed upon it sacrificial template layer 813 that includes inorganic nanomaterials. Sacrificial template layer 813 that includes inorganic nanomaterials is then embossed. Thermally stable backfill layer 815 is applied so as to planarize sacrificial template layer 813. This stack is then inverted and laminated to receptor substrate 816 where thermally stable backfill layer 815 is now in contact with receptor substrate 816 and sacrificial template layer 813a that includes inorganic nanomaterials as shown in the fourth diagram. Support substrate 811 is removed. Bake-out then begins to densify sacrificial template layer 813b to form layer of nanomaterials 813c and the bake-out is completed to form densified inorganic layer 813d which forms the embedded nanostructure along with backfill 815 on receptor substrate 816.

Objects and advantages of this disclosure are further illustrated by the following examples, but the particular materials and amounts thereof recited in these examples, as well as other conditions and details, should not be construed to unduly limit this disclosure.

## Examples

All parts, percentages, ratios, etc. in the examples are by weight, unless noted otherwise. Solvents and other reagents used were obtained from Sigma-Aldrich Corp., St. Louis, Missouri unless specified differently.

Example 1 - Acrylate Containing Zirconia Nanoparticles, which is not part of the presently claimed invention

200 grams of zirconia sol (a 49.3 wt% aqueous dispersion of approximately 10nm zirconia) were added to a one-neck round bottom flask. To this dispersion was added, 400 grams of 1 - methoxy-2-propanol, 0.88 grams of a 5 wt% aqueous solution of PROSTAB 5198, 121.6 grams of phenoxyethylacrylate (PEA) and 23.0 grams of succinic acid mono-(2-acryloyloxy-ethyl) ester. The resultant mixture was a slightly hazy, translucent dispersion.

The flask was then placed on a rotary evaporator to remove the water and 1-methoxy-2-propanol by vacuum distillation. Once the rotary evaporator vacuum reached 28 in (71 cm) Hg and the water bath reached 80°C the batch was held for approximately one hour to minimize the residual solvent. No distillate was visible for at least the last 30 minutes of the distillation. The total distillation time was approximately three hours. After the distillation, the batch was filtered through a coarse nylon mesh into an 8 ounce amber bottle. The final yield was 216.2 grams of a slightly viscous, translucent dispersion.

1.3 wt% IRGACURE 369 was added to the $ZrO_2$/PEA resin and rolled for 4 hours until the resin dissolved. A small amount of the $ZrO_2$/PEA/Irg369 solution was provided at one edge of a polymer master tool with 600 nm 1:1 structure of saw tooth grooves. A carrier film of 2 mil (51 micron) unprimed PET was placed on top of the resin and tool and the entire sandwich of tool, resin and PET was drawn at 0.3 m/min through a knife coater with minimal gap. The sandwich was then exposed to light from a bank of Philips blacklight blue 15W bulbs (wavelength 350 nm - 410 nm) for 1- 4 minutes to cure the $ZrO_2$/PEA/Irg369 resin. The tool was removed from the cured, structured $ZrO_2$/PEA/Irg369 film which remained temporarily attached to the unprimed PET carrier film. The thickness of the cured, structured film was approximately 3-5 microns.

Backfill Coating

A sample of the cured PEA/high index film (2 in x 3 in - 50 mm x 75 mm) was coated with PERMANEW 6000 L510-1, which was applied to the embossed film sample by spin coating. Prior to spin coating, the PERMANEW 6000 was diluted to 17.3 wt% in isopropanol and filtered through a 0.8 $\mu$m filter. A glass microscope slide was used to support the film during the coating process. The spin parameters were 500 rpm/3 sec (solution application), and 2000 rpm/10 sec (spin down). The sample was removed from spin coater and placed on a hotplate at 50°C for 30 min to complete the drying process. After drying, the backfilled sample was placed on a hotplate at 70°C for 4 hours to cure the PERMANEW 6000.

Adhesion Promotion Layer Coating

Glass slides, 50 mm x 75 mm, were cleaned with IPA and a lint free cloth. The slide was mounted on the vacuum chuck of a Model WS-6505-6npp/lite spin coater. A vacuum of 64 kPa (19 inches of Hg) was applied to hold the glass to the chuck. The spin coater was programmed for 500 RPM for 5 seconds (coating application step) then 3000 RPM for 15 sec (spin step), then 1000 RPM for 10 seconds (dry step).

A solution of CYCLOTENE (CYCLOTENE 3022 63 resin, 63 wt% stock, from DOW Chemical Company, Midland, MI) was diluted to 32 wt% in mesitylene. Approximately 1-2 mL of the CYCLOTENE solution was applied to the glass slide during the coating application portion of the spin cycle. The slide was then removed from the spin coater and put on a hotplate at 50°C for 30 minutes and covered with an aluminum tray. The slide was then allowed to cool to room temperature.

Lamination

The planarized microstructure was laminated at 230°F (110°C), coating side down, to the CYCLOTENE-coated cleaned glass slide using a thermal film laminator (GBC Catena 35, GBC Document Finishing, Lincolnshire, IL). The laminated sample was removed from the laminator and allowed cool to room temperature. To remove any air bubbles left by the lamination step, the laminated sample was placed in an autoclave at 75°C and 6.5 kg/cm2 for 30 minutes.

Bake-out

After autoclaving, the unprimed PET supporting the film stack was peeled from the sample, leaving all other layers adhered to the glass slide. The sample was placed in a box furnace (Lindberg Blue M box furnace model BF51732PC-1, Asheville NC, USA) and brought from 25°C to 500°C at a rate of approximately 10°C/min. The furnace was held at 500°C for one hour to decompose the sacrificial material. The furnace and sample were allowed to cool down to ambient temperature. The result was an embedded optical nanostructure as shown in Fig. 9 shows substrate 901 (glass slide in this embodiment), silica layer 903, and embedded nanostructure 905 (zirconia layer).

Example 2 - Acrylate Containing Titania Nanoparticles, which is not part of the presently claimed invention Synthesis of PMMA/PBMA copolymer

A copolymer containing poly(methyl methacrylate) (PMMA) and poly(butyl methacrylate) (PBMA) was synthesized as a curable sacrificial binder for high-index titania nanoparticles. The polymerization was performed via standard free radical polymerization techniques. The mole percent of the copolymer was chosen to be approximately 25% PMMA, and 75% PBMA, and the solids concentration set at 40 wt%. The copolymer was produced by adding 7.5g MMA (75 mmol), 32.0 g butyl methacrylate (BMA) (225 mmol), 100 g methyl ethyl ketone (MEK), 39.5 mg VAZO 67 Initiator, and 121 mg (0.6 mmol) t-dodecylmercaptan chain transfer agent into an amber bottle. The bottle was purged with nitrogen for 1 minute, and then heated at 60°C for 24 hours with agitation. The solutions were allowed to cool to room temperature before exposing to air. Solutions appeared clear and slightly viscous due to the increase in molecular weight.

Blend with Titania Nanoparticles

A solution was created using the above synthesized copolymer blended with high index titania nanoparticles. A 1:1 w:w solution was created by mixing 5 g of the 40 wt% PMMA/PBMA copolymer with 10 g of a 20 wt% dispersion of 50 nm titania nanoparticles in MEK (NAT-311 K, Nagasc Chemical, Tokyo) in an amber vial, along with 1 wt% (40 mg) IRGACURE 184 (BASF, Ludwigshafen, Germany). The solution was allowed to mix with a magnetic stir bar overnight at room temperature. Solutions were coated using a 10 mil (250 microns) wet coating thickness using a round notch-bar into a nanostructured polymer coated with a TMS release coating. The film was allowed to dry in air for two minutes before laminating the stack to unprimed PET and curing with two passes of ultraviolet irradiation at 30 feet/min (9.1 m/min)(H-bulb, Fusion Products). The nanostructured tool was then peeled off to leave behind a nanostructured acrylate/titania blend.

Backfill Coating

PERMANEW 6000 was diluted to a final concentration of 17.3 wt% with isopropyl alcohol. A sample of the cured PMMA/PBMA/high index film (~5cm x 7.5cm) was coated with the diluted PERMANEW 6000, which was applied to the embossed film sample by spin coating. A glass microscope slide was used to support the film during the coating process. The spin parameters were 500 rpm/5 sec (solution application), 2000 rpm/15 sec (spin down), and 1000 rpm/20 sec (dry).The sample was removed from spin coater and placed on a hotplate at 70°C for 4 hours to complete the drying/curing process.

Adhesion Promotion Layer Coating

Polished glass slides, 50 mm x 50 mm, were first cleaned with a lint free cloth, then sonicated in a wash chamber for 20 minutes with detergent, then 20 minutes in each of two cascading rinse chambers with heated water. The slides were then dried for 20 minutes in an oven with circulating air. The slide was mounted on the vacuum chuck of a Model WS-6505-6npp/lite spin coater. A vacuum of 64 kPa (19 inches of Hg) was applied to hold the glass to the chuck. The spin coater was programmed for 500 RPM for 5 seconds (coating application step) then 2000 RPM for 15 sec (spin step), then 1000 RPM for 10 seconds (dry step).
A solution of CYCLOTENE (CYCLOTENE 3022 63 resin, 63 wt% stock, from DOW Chemical Company, Midland, MI) was diluted to 25 wt% in mesitylene. Approximately 1-2 milliliters of the CYCLOTENE solution 25 wt% applied to the glass slide during the coating application portion of the spin cycle. The slide was then removed from the spin coater and put on a hotplate at 50°C for 30 minutes, covered with an aluminum tray. The slide was then allowed to cool to room temperature.

Lamination

The planarized microstructure was laminated at 230°F (110°C), coating side down, to the CYCLOTENE-coated cleaned glass slide using a thermal film laminator (GBC Catena 35, GBC Document Finishing, Lincolnshire, IL). The laminated sample was removed from the laminator and allowed cool to room temperature. To remove any air bubbles left by the lamination step, the laminated sample was placed in an autoclave at 75°C and 6.5 kg/cm2 for 30 minutes.

Bake-out

After the autoclave, the unprimed PET supporting the film stack was peeled from the sample, transferring all layers to the glass slide. For this sample, the bake step was a two step process. First, the laminated sample was placed in a muffle furnace, the furnace (Lindberg, Blue M model #51642-HR, Ashville, NC USA) was purged with Nitrogen and the atmosphere was maintained at below 20 ppm of Oxygen. The temperature was ramped from 25°C to 350°C at a rate of 5°C/min. Then the temperature was ramped at approximately 1°C/min from 350°C to 425°C and the furnace was held at 425°C for two hours, then the furnace and sample were allowed to cool down naturally. Second, the glass slide was transferred to another furnace (Lindberg, Blue M BF51732PC-1, Ashville, NC USA) and re-fired in an air atmosphere. The temperature was ramped from 25°C to 500°C at a rate of 10°C/min and then held for 1 hour at 500°C, then the furnace was turned off and the sample and furnace were allowed to cool back down to room temperature naturally. During the bake step, the acrylate binder decomposed and the high index nanoparticle filler densified to form a thin layer that planarized the structured silsesquioxane. The result was an embedded optical nanostructure.

Example 3 -Polynorbornene with Zirconia Nanoparticles , which is not part of the presently claimed invention Formulation and Coating

To prepare the coating solution, 1.67 g of a (PDM 1086, 44.8 wt% polynorbomene) solution, available from Promerus Electronics, Brecksville, OH, was dissolved in 2.3 g of methyl isobutylketone (MIBK). Then, 0.5 g of $ZrO_2$ functionalized with methoxyethoxyacetic acid (MEEAA) (51.2 wt% in MIBK) was added to the PDM 1086/MIBK blend and mixed overnight on a stirplate to make a 22 wt% solution. The solution was coated with a 2 mil (51 $\mu$m wet coating thickness into a TMS-coated microreplicated polymer tool (600 nm pitch, 1.2 $\mu$m height sawtooth pattern) and baked at 120°C for 5 minutes to remove solvent in a recirculating air oven. The film was then laminated to unprimed PET at 280°F (138°C), 80 psi at a slow rate of speed. Next, the stack was crosslinked through the unprimed PET using 3 passes of ultraviolet irradiation (RPC Industries UV Processor QC 120233AN/DR, Plainfield, IL, 30 fpm, $N_2$). Finally, the film was placed in a post-cure oven at 90°C for 4 minutes to accelerate the crosslinking reaction, and the polymer tool was peeled away, leaving behind a microreplicated PDM/$ZrO_2$ coating.

Backfill Coating

PERMANEW 6000 was diluted to a final concentration of 17.3 wt% with isopropyl alcohol. A sample of the cured PDM/ high-index film (5 cm x 7.5 cm) was coated with the diluted PERMANEW 6000, which was applied to the cured film sample by spin coating. A glass microscope slide was used to support the film during the coating process. The spin parameters were 500 rpm/5 sec (solution application), 2000 rpm/15 sec (spin down), and 1000 rpm/20 sec (dry).The sample was removed from spin coater and placed on a hotplate at 70°C for 4 hours to complete the drying/curing process.

Adhesion Promotion Layer Coating

Polished glass slides, 50 mm x 50 mm, were first cleaned with a lint free cloth, then sonicated in a wash chamber for 20 minutes with detergent, then 20 minutes in each of two cascading rinse chambers with heated water. The slides were then dried for 20 minutes in an oven with circulating air. The slide was mounted on the vacuum chuck of a Model WS-6505-6npp/litc spin coater. A vacuum of 64 kPa was applied to hold the glass to the chuck. The spin coater was programmed for 500 RPM for 5 seconds (coating application step) then 2000 RPM for 15 sec (spin step), then 1000 RP PM for 10 seconds (dry step).
A solution of CYCLOTENE 3022 63 resin, 63 wt% stock, from DOW Chemical Company, Midland, MI) was diluted to 25 wt% in mesitylene. Approximately 1-2 mL of the CYCLOTENE 25 wt% solution was applied to the glass slide during the coating application portion of the spin cycle. The slide was then removed from the spin coater and put on a hotplate at 50°C for 30 minutes, covered with an aluminum tray. The slide was then allowed to cool to room temperature.

Lamination

The planarized microstructure was laminated at 230°F (110°C), coating side down, to the CYCLOTENE-coated cleaned glass slide using a thermal film laminator (GBC Catena 35, GBC Document Finishing, Lincolnshire, IL). The laminated sample was removed from the laminator and allowed cool to room temperature. To remove any air bubbles left by the lamination step, the laminated sample was placed in an autoclave at 75°C and 6.5 kg/cm2 for 30 minutes.

Bake-out

After the autoclave, the PET film supporting the PDM/$ZrO_2$ template tool was peeled from the sample, transferring the replicated PDM/$ZrO_2$ backfill material to the glass slide. The laminated sample was placed in a muffle furnace, the furnace was purged with Nitrogen and the atmosphere was maintained at below 20 ppm of Oxygen. The temperature was ramped from 25°C to 350°C at a rate of approximately 5°C/min . Then the temperature was ramped at approximately 1°C/min from 350°C to 425°C and the furnace was held at 425°C for two hours, then the furnace and sample were allowed to cool down naturally. During the bake step, the PDM sacrificial template decomposes and the high index nanoparticle filler densifies to form a thin layer that planarizes the structured silsesquioxane. The result is an embedded optical nanostructure.

Example 4 - Embossed PVA with Zirconia Nanoparticles , which is not part of the presently claimed invention Formulation and Coating

A 3000 mL 3-neck flask equipped with a stir bar, stir plate, condenser, heating mantle and thermocouple/temperature controller was charged with 1860 grams deionized water and 140 grams of Kuraray PVA-236 (polyvinyl alcohol, Kuraray America Inc. Houston, Texas). This mixture was heated to 80°C and held for six hours with moderate mixing. The solution was cooled to room temperature and transferred to a 4-liter poly bottle. The percent solids of this clear, slightly viscous solution was measured to be 6.7 wt% (Solution A). In a separate 4 oz glass bottle, 14.95 grams zirconia sol (49.3% solids dispersion of approximately 10 nm diameter zirconia particles in water) and 95.05 grams of deionized water were charged and mixed until homogeneous. This resulted in a 6.7 wt% solids dispersion of zirconia particles in water (Solution B). Finally, the zirconia-PVA blended was prepared by adding 50.0 grams of Solution A and 50.0 grams of Solution B to a clean 4 oz. glass bottle. This blend was mixed for approximately 5 minutes using a magnetic stir bar and stir plate. The resulting blend was a translucent, slightly viscous 50/50 solids blend of zirconia/PVA in water at 6.7 wt% solids.

The solution was coated with a 8 mil (200 $\mu$m wet coating thickness) onto 2 mil thick unprimed PET and dried at 100°C for 5 minutes to remove solvent in a recirculating air oven. A release coating was applied to a polymer tool having 600nm pitch linear grooves by depositing a silicon containing layer by plasma deposition using a Plasma-Therm batch reactor (Plasm-Therm Model 3032 available from Plasma-Therm, St. Petersberg, FL). The dried PVA film was embossed against the polymer tool at a temperature of 171°C (340°F) in a hot press under a pressure of 30,000 phi for 3 minutes. The polymer tool was then removed from the embossed PVA film.

Backfill Coating

A sample of the embossed film (2 in x 3 in - 50 mm x 75 mm) was coated with PERMANEW 6000 L510-1, which was applied to the embossed film sample by spin coating. Prior to spin coating, the PERMANEW 6000 was diluted to 17.3 wt% in isopropanol and filtered through a 0.8 $\mu$m filter. A glass microscope slide was used to support the film during the coating process. The spin parameters were 500 rpm/3 sec (solution application), and 2000 rpm/10 sec (spin down). The sample was removed from spin coater and placed on a hotplate at 50°C for 30 min to complete the drying process. After drying, the backfilled sample was placed on a hotplate at 70°C for 4 hours to cure the PERMANEW 6000.

Adhesion Promotion Layer Coating

Glass slides, 50 mm x 75 mm, were cleaned with a IPA and a lint free cloth. The slide was mounted on the vacuum chuck of a Model WS-6505-6npp/lite spin coater. A vacuum of 64 kPa (19 inches of Hg) was applied to hold the glass to the chuck. The spin coater was programmed for 500 RPM for 5 seconds (coating application step) then 3000 RPM for 15 sec (spin step), then 1000 RPM for 10 seconds (dry step).

A solution of CYCLOTENE (CYCLOTENE 3022 63 resin, 63 wt% stock, from DOW Chemical Company, Midland, MI) was diluted to 32 wt% in mesitylene. Approximately 1-2 mL of the CYCLOTENE solution was applied to the glass slide during the coating application portion of the spin cycle. The slide was then removed from the spin coater and put on a hotplate at 50°C for 30 minutes and covered with an aluminum tray. The slide was then allowed to cool to room temperature.

Lamination

The planarized microstructure was laminated at 230°F (110°C), coating side down, to the CYCLOTENE-coated cleaned glass slide using a thermal film laminator (GBC Catena 35, GBC Document Finishing, Lincolnshire, IL). The laminated sample was removed from the laminator and allowed cool to room temperature. To remove any air bubbles left by the lamination step, the laminated sample was placed in an autoclave at 75°C and 6.5 kg/cm2 for 30 minutes.

Bake-out

After autoclaving, the unprimed PET supporting the film stack was peeled from the sample, leaving all other layers adhered to the glass slide. The sample was placed in a box furnace (Lindberg Blue M box furnace model BF51732PC-1, Asheville NC, USA) and brought from 25°C to 500°C at a rate of approximately 10°C/min. The furnace was held at 500°C for one hour to decompose the sacrificial material. The furnace and sample were allowed to cool down to ambient temperature. The result was an embedded optical nanostructure.

Example 5 - Particle-free Sacrificial Support Substrate, which is not part of the presently claimed invention

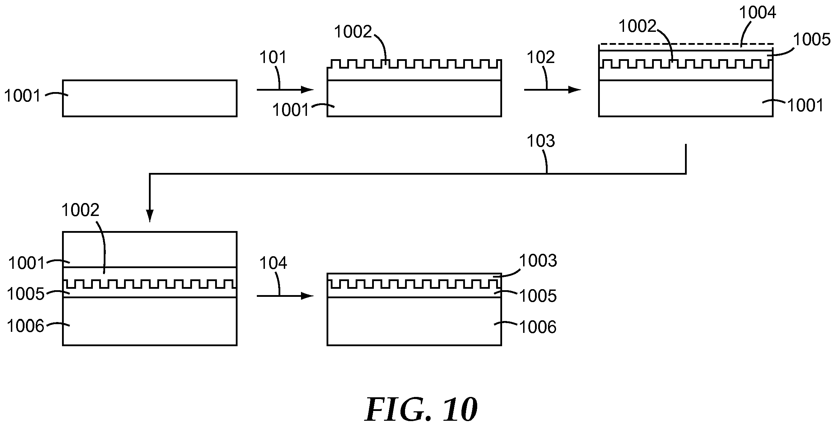

Fig. 10 is a schematic of the process used in Example 5. Fig. 10 presents a schematic of a flow diagram of a process for making and using a disclosed transfer film that has a sacrificial support substrate and a sacrificial template layer. In Fig. 10 sacrificial support substrate 1001 has a releasable surface and is substantially devoid of inorganic nanomaterials. Sacrificial template layer 1002 comprising inorganic nanomaterials and sacrificial material is cast upon sacrificial support substrate 1001 where it is cured while being exposed to a master having a structured surface (step 101). Sacrificial template layer 1002 has a first surface applied to the releasable surface of sacrificial support substrate 1001 and a second structured surface. Thermally stable backfill 1005 is disposed upon the second surface of sacrificial template layer 1002 so as to planarize the sacrificial template layer, thereby producing embedded nanostructure in the resulting article (step 102). As part of step 102, an optional adhesion promoting layer 1004 can be applied to backfill layer 1005 or to receptor substrate 1006. This article can be offered as a transfer film having embedded nanostructure. The article (transfer film) described above can be laminated to receptor substrate 1006 as shown in step 103. The laminate containing sacrificial support substrate 1001 and thermally stable backfill 1005 and planarized sacrificial template layer 1002 can be baked to remove any organic material and to leave a densified layer of inorganic nanomaterials 1003 (step 104).

In this embodiment, a sacrificial support substrate is used in a cast and cure process with a methacrylate-based syrup to form a sacrificial template layer on the substrate. The syrup is filled with inorganic nanomaterials (e.g. nanozirconia) or a suitable precursor to titania or zirconia (e.g. an organozirconate or organotitanate). The template layer is backfilled with a silsesquioxane precursor (e.g. PERMANEW 6000, California Hardcoats), laminated to a receptor surface, and then baked at elevated temperature (>300°C). During the bake step, the sacrificial support layer and the sacrificial template layer both decompose and the nanoparticle filler densifies to form a thin, densified layer of nanoparticles. The result is an embedded optical nanostructure.

Example 6. - Polymer-derived ceramic particles

This example describes a method to prepare a planarization layer composed of a polymer-derived ceramic. 10% of the formulation includes a photocurable polymer resin to aid in the curing process. Both ultraviolet irradiation and heat is used to cure the photopolymer and polysilazane material, respectively. Before loading these materials into the glass vial, the glass vial is dried at 80°C in a recirculating air oven to remove traces of water adsorbed to the vial, since PSZ is very sensitive to $O_2$ and water. To prepare the formulation, 1.8 g of KiON Polysilazane (HTT-1800, AZ Electronic Materials, Branchburg, NJ), 0.2 g of SR444C (Sartomer Co., Exton Pa), 20 mg of dicumyl peroxide (Aldrich) and 20 mg of dimethoxyacetylphenone (Aldrich). Solutions were mixed overnight at room temperature, then outgassed under reduced pressure for 90 minutes. The solutions were coated into a release coated nanostructured polymer tool at 5 mil (250 μm) wet coating thickness using a notch bar, then laminated against unprimed PET. The stack was then cured through the unprimed PET layer using three passes of a Fusion Products (H-Bulb) at 30 feet per minute to cure the layer to a tack-free state. After curing the polymer tool was removed from the coating, leaving behind nanostructured polymer-derived ceramic template.

Backfill Coating

PERMANEW 6000 was diluted to a final concentration of 17.3 wt% with isopropyl alcohol. A sample of the polymer-derived ceramic film (50mm x 75mm,~2 in x 3 in) was coated with the diluted PERMANEW 6000, which was applied to the cured film sample by spin coating. A glass microscope slide was used to support the film during the coating process. The spin parameters were 500 rpm/5 sec (solution application), 2000 rpm/15 sec (spin down), and 1000 rpm/20 sec (dry).The sample was removed from spin coater and placed on a hotplate at 70°C for 4 hours to complete the drying/curing process.

Adhesion Promotion Layer Coating

Polished glass slides, 50 mm x 50 mm, were first cleaned with a lint free cloth, then sonicated in a wash chamber for 20 minutes with detergent, then 20 minutes in each of two cascading rinse chambers with heated water. The slides were then dried for 20 minutes in an oven with circulating air. The slide was mounted on a vacuum chuck of a Model WS-6505-6npp/lite spin coater. A vacuum of 64 kPa (19 inchs of Hg) was applied to hold the glass to the chuck. The spin coater was programmed for 500 RPM for 5 seconds (coating application step) then 2000 RPM for 15 sec (spin step), then 1000 RP PM for 10 seconds (dry step).

A solution of CYCLOTENE (Cyclotene 3022 63 resin, 63 wt% stock, from DOW Chemical Company, Midland, MI) was diluted to 25%w/w in mesitylene. Approximately 1-2 milliliters of the cyclotene solution 25 wt% applied to the glass slide during the coating application portion of the spin cycle. The slide was then removed from the spin coater and put on a hotplate at 50°C for 30 minutes, covered with an aluminum tray. The slide was then allowed to cool to room temperature.

Lamination

The planarized microstructure was laminated at 230°F (110°C), coating side down, to the Cyclotene coated cleaned glass slide using a thermal film laminator (GBC Catena 35, GBC Document Finishing, Lincolnshire, IL). The laminated sample was removed from the laminator and allowed cool to room temperature. To remove any air bubbles left by the lamination step, the laminated sample was placed in an autoclave at 75°C and 6.5 kg/cm2 for 30 minutes.

Bake-out

After the autoclave, the unprimed PET supporting the film stack was peeled from the sample, transferring all layers to the glass slide. For this sample, the bake step was a two-step process. First, the laminated sample was placed in a muffle furnace, the furnace (Lindberg, Blue M model #51642-HR, Ashville, NC USA) was purged with nitrogen and the atmosphere was maintained at below 20 ppm of Oxygen. The temperature was ramped from 25°C to 350°C at a rate of approximately 5°C/min . Then the temperature was ramped at approximately 1°C/min from 350°C to 425°C and the furnace was held at 425°C for two hours, then the furnace and sample were allowed to cool down naturally. Second, the glass slide was transferred to another furnace (Lindberg, Blue M BF51732PC-1, Ashville, NC USA) and re-fired in an air atmosphere. The temperature was ramped from 25°C to 500°C at a rate of 10°C/min and then held for 1 hour at 500°C, then the furnace was turned off and the sample and furnace were allowed to cool back down to room temperature naturally. During the bake step, the acrylate binder decomposes and the high index nanoparticle filler densifies to form a thin layer that planarizes the structured silsesquioxane. The result is an embedded optical nanostructure.

Example 7 - Titania nanoparticles and Inorganic Binder

In this embodiment, high index titania nanoparticles and an alkytitanate sol (titanium butoxide, $Ti(OBu)_4$) blend into a radiation curable resin. In order to prepare the titanium butoxide sol, we follow an established literature procedure described in Richmond et. al (*J. Vac. Sci. Tech.* B, *29*, 2, (2011). 6.81 mL of $Ti(OBu)_4$ is mixed with 1.92 mL of diethanolamine and 9.09 mL of 2-methoxyethanol. Then, 0.18 mL of acetic acid and 2 mL distilled $H_2O$ is prepared separately and added to the $Ti(OBu)_4$ solution dropwise and stirred for three days at room temperature with a magnetic stir bar. The total solution concentration of the $Ti(OBu)_4$ formulation is 52 wt. %. Commercially available Titania nanoparticles dispersed in methyl ethyl ketone was purchased from Nagase ChemTex (Tokyo, Japan, NAT-311K, 20% by weight). In a separate vial, SR444C (Sartomer Co, Exton, PA) is mixed into anhydrous alcohol at 48.2 wt. % along 1 wt% IRGACURE 819 by weight relative to the polymer and magnetically stirred until the solution becomes homogenous. Then, the SR444C is mixed with the inorganic components to create a 50/25/25 mixture by weight of SR444C/$TiO_2$ nanoparticles/Ti(OBu)$_4$. In an amber colored bottle, 2.07g SR444C, 2.44g NAT-311K, and 0.97 Ti(OBu)$_4$ is added and sonicated for 10 minutes. The solution is coated with a 2 mil (51 μm wet coating thickness into a TMS-coated microreplicated polymer tool (600 nm pitch, 1.2 μm height sawtooth pattern) and baked at 85°C for 10 minutes to remove solvent in a recirculating air oven. The film is then laminated to unprimed PET at 280°F (138°C), 80 psi at a slow rate of speed. Next, the stack is crosslinked through the unprimed PET using 2 passes of ultraviolet irradiation (Fusion Products, D-Bulb, 30 fpm, N$_2$). The polymer tool is peeled away, leaving behind a microreplicated SR444/TiO2/Ti(OBu)$_4$ coating.

Backfill Coating

PERMANEW 6000 is diluted to a final concentration of 17.3 wt% with isopropyl alcohol. A sample of the microreplicated SR444/TiO2/Ti(OBu)$_4$ film (5 cm x 7.5 cm) is coated with the diluted PERMANEW 6000, which was applied to the film sample by spin coating. A glass microscope slide is used to support the film during the coating process. The spin parameters are 500 rpm/5 sec (solution application), 2000 rpm/15 sec (spin down), and 1000 rpm/20 sec (dry). The sample is removed from spin coater and placed on a hotplate at 70°C for 4 hours to complete the drying/curing process.

Adhesion Promotion Layer Coating

Polished glass slides, 50 mm x 50 mm, are first cleaned with a lint free cloth, then sonicated in a wash chamber for 20 minutes with detergent, then 20 minutes in each of two cascading rinse chambers with heated water. The slides are then dried for 20 minutes in an oven with circulating air. The slide is mounted on the vacuum chuck of a Model WS-6505-6npp/lite spin coater. A vacuum of 64 kPa is applied to hold the glass to the chuck. The spin coater is programmed for 500 RPM for 5 seconds (coating application step) then 2000 RPM for 15 sec (spin step), then 1000 RP PM for 10 seconds (dry step).

A solution of CYCLOTENE 3022 63 resin, 63 wt% stock, from DOW Chemical Company, Midland, MI) is diluted to 25 wt% in mesitylene. Approximately 1-2 mL of the CYCLOTENE 25 wt% solution is applied to the glass slide during the coating application portion of the spin cycle. The slide is then removed from the spin coater and put on a hotplate at 50°C for 30 minutes, covered with an aluminum tray. The slide is then allowed to cool to room temperature.

Lamination

The planarized microstructure is laminated at 230°F (110°C), coating side down, to the CYCLOTENE-coated cleaned glass slide using a thermal film laminator (GBC Catena 35, GBC Document Finishing, Lincolnshire, IL). The laminated sample is removed from the laminator and allowed cool to room temperature. To remove any air bubbles left by the lamination step, the laminated sample is placed in an autoclave at 75°C and 6.5 kg/cm2 for 30 minutes.

Bake-out

After the autoclave, the PET liner supporting the SR444/TiO2/Ti(OBu)$_4$ template tool is peeled from the sample, transferring the replicated SR444/TiO2/Ti(OBu)$_4$ backfill material to the glass slide. The laminated sample is placed in a muffle furnace, the furnace (Lindberg, Blue M model #51642-HR, Ashville, NC USA) was purged with nitrogen and the atmosphere is maintained at below 20 ppm of Oxygen. The temperature was ramped from 25°C to 600°C at a rate of approximately 10°C/min. The furnace is held at 600°C for three hours, then the furnace and sample are allowed to cool down naturally to room temperature. During the bake step, the SR444C sacrificial template and the butoxide ligands decompose and the high index nanoparticles + binder densifies to form a thin layer that planarizes the structured silsesquioxane. The result is an embedded optical nanostructure.

Examples 1-5 are reference examples, not according to the invention and examples 6-7 are examples according to the invention.

Although specific examples and embodiments of the present invention have been illustrated and described herein, it will be appreciated by those of ordinary skill in the art that a variety of alternate and/or equivalent implementations can be substituted for the specific embodiments shown and described without departing from the scope of the present invention which is defined by the features of the claims. This application is intended to cover any adaptations or variations of the specific embodiments discussed herein. Therefore, it is intended that this disclosure be limited only by the claims and the equivalents thereof.

**Claims**

1. A transfer film (200, 300, 400, 500, 600) comprising:

    a sacrificial support substrate (301, 402, 503, 603);
    a sacrificial template layer (205, 305, 405, 504, 605) having a first surface applied to the sacrificial support substrate and a second surface opposite the first surface, wherein the second surface comprises a structured surface comprising:

        a sacrificial materials component; and a thermally stable materials component; and
        a thermally stable backfill layer (207, 307, 407, 507, 607) disposed upon the second surface of the sacrificial template layer (205, 305, 405, 504, 605),

    wherein the thermally stable backfill layer (207, 307, 407, 507, 607) has a structured surface conforming to the structured surface of the template layer (205, 305, 405, 504, 605), and
    wherein the thermally stable materials component of the sacrificial template layer (205, 305, 405, 504, 605) includes a binder, wherein the binder is formed from a binder precursor comprising metal alkoxide or polysilazanes.

2. A transfer film according to claim 1, wherein the binder precursor comprises metal alkoxide and the metal alkoxide is selected from an alkyl titanate, an alkyl zirconate or an alkyl silicate.

3. A transfer film according to claim 1, wherein the thermally stable materials component further comprises inorganic nanoparticles.

4. A transfer film according to claim 1, wherein the composition of the sacrificial materials component of the sacrificial template layer ranges from 40 to 99 wt%.

5. A transfer film according to claim 1, wherein the sacrificial support substrate (301, 402, 503, 603) comprises inorganic nanomaterials and sacrificial material.

6. A transfer film according to claim 1, wherein the sacrificial template layer (205, 305, 405, 504, 605) comprises inorganic nanomaterials and sacrificial material.

**Patentansprüche**

1. Transferfolie (200, 300, 400, 500, 600), aufweisend:

    ein Opferträgersubstrat (301, 402, 503, 603);
    eine Opferschablonenschicht (205, 305, 405, 504, 605) mit einer ersten Oberfläche, die auf dem Opferträgersubstrat aufgebracht ist, und einer zweiten Oberfläche gegenüber der ersten Oberfläche, wobei die zweite Oberfläche eine strukturierte Oberfläche aufweist, die Folgendes aufweist:

        eine Opfermaterialkomponente; und eine thermisch stabile Materialkomponente; und
        eine thermisch stabile Hinterfüllungsschicht (207, 307, 407, 507, 607), die auf der zweiten Oberfläche der Opferschablonenschicht (205, 305, 405, 504, 605) angeordnet ist,

    wobei die thermisch stabile Hinterfüllungsschicht (207, 307, 407, 507, 607) eine strukturierte Oberfläche aufweist, die der strukturierten Oberfläche der Schablonenschicht (205, 305, 405, 504, 605) entspricht, und
    wobei die thermisch stabile Materialkomponente der Opferschablonenschicht (205, 305, 405, 504, 605) ein Bindemittel enthält, wobei das Bindemittel aus einem Bindemittelvorläufer gebildet ist, der Metallalkoxid oder Polysilazane aufweist.

2. Transferfolie nach Anspruch 1, wobei der Bindemittelvorläufer ein Metallalkoxid aufweist und das Metallalkoxid aus einem Alkyltitanat, einem Alkylzirkonat oder einem Alkylsilikat ausgewählt ist.

3. Transferfolie nach Anspruch 1, wobei die thermisch stabile Materialkomponente weiterhin anorganische Nanopartikel aufweist.

**4.** Transferfolie nach Anspruch 1, wobei die Zusammensetzung der Opfermaterialkomponente der Opferschablonenschicht im Bereich von 40 bis 99 Gew.-% liegt.

**5.** Transferfolie nach Anspruch 1, wobei das Opferträgersubstrat (301, 402, 503, 603) anorganische Nanomaterialien und Opfermaterial aufweist.

**6.** Transferfolie nach Anspruch 1, wobei die Opferschablonenschicht (205, 305, 405, 504, 605) anorganische Nanomaterialien und Opfermaterial aufweist.

**Revendications**

**1.** Film de transfert (200, 300, 400, 500, 600), comprenant :

un substrat de support sacrificiel (301, 402, 503, 603);
une couche matrice sacrificielle (205, 305, 405, 504, 605) ayant une première surface appliquée au substrat de support sacrificiel et une deuxième surface opposée à la première surface, dans lequel la deuxième surface comprend une surface structurée comprenant :

un composant de matériaux sacrificiels ; et un composant de matériaux thermiquement stables ; et
une couche de remplissage thermiquement stable (207, 307, 407, 507, 607) disposée sur la deuxième surface de la couche matrice sacrificielle (205, 305, 405, 504, 605),

dans lequel la couche de remplissage thermiquement stable (207, 307, 407, 507, 607) a une surface structurée épousant la surface structurée de la couche matrice (205, 305, 405, 504, 605), et
dans lequel le composant de matériaux thermiquement stables de la couche matrice sacrificielle (205, 305, 405, 504, 605) comprend un liant, le liant étant formé à partir d'un précurseur de liant comprenant un alcoxyde métallique ou des polysilazanes.

**2.** Film de transfert selon la revendication 1, dans lequel le précurseur de liant comprend de l'alcoxyde métallique et l'alcoxyde métallique est choisi parmi un titanate d'alkyle, un zirconate d'alkyle ou un silicate d'alkyle.

**3.** Film de transfert selon la revendication 1, dans lequel le composant de matériaux thermiquement stables comprend en outre des nanoparticules inorganiques.

**4.** Film de transfert selon la revendication 1, dans lequel la composition du composant de matériaux sacrificiels de la couche matrice sacrificielle va de 40 à 99 % en poids.

**5.** Film de transfert selon la revendication 1, dans lequel le substrat de support sacrificiel (301, 402, 503, 603) comprend des nanomatériaux inorganiques et un matériau sacrificiel.

**6.** Film de transfert selon la revendication 1, dans lequel la couche matrice sacrificielle (205, 305, 405, 504, 605) comprend des nanomatériaux inorganiques et un matériau sacrificiel.

**FIG. 1A**

**FIG. 1B**

**FIG. 1C**

200

**FIG. 2**

207

205

300

**FIG. 3**

307

305

302

301

400

**FIG. 4**

407

405

402

500

507

504

503

**FIG. 5**

600

607

605

603

**FIG. 6**

*FIG. 7*

2.00 μm

*FIG. 9*

**FIG. 8A**

**FIG. 8B**

EP 2 961 601 B1

## FIG. 10

EP 2 961 601 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2010151207 A
- US 20140021492 A
- US 13723716 B
- US 13723675 B
- US 4766023 A, Lu
- US 8213082 B, Gaides
- US 6398370 B, Chiu
- US 6858253 B, Williams
- WO 20140021492 A
- US 20120329959 A1, Jones
- US 7241437 B, Davidson
- US 6376590 B, Kolb
- WO 2012082536 PCT, Baran
- US 4472480 A, Olson
- US 4567073 A
- US 4614667 A, Larson
- US 2005118352 A, Suwa
- US 6396079 B, Hayashi

### Non-patent literature cited in the description

- **SHAW et al.** Negative photoresists for optical lithography. *IBM Journal of Research and Development,* 1997, vol. 41, 81-94
- **R.E. MISTLER ; E.R. TWINAME.** Tape Casting: Theory and Practice. American Ceramic Society, 2000
- Nanomaterials Chemistry. Wiley-VCH, 2007
- **P. CHINIWALLA.** *IEEE Trans. Adv. Packaging,* 2001, vol. 24 (1), 41
- **RO.** *Adv. Mater.,* 2007, vol. 19, 705-710
- **K. KONDOH et al.** *J. of Non-Crystalline Solids,* 1994, vol. 178, 189-98
- **T-K. KIM et al.** *Mat. Res. Soc. Symp. Proc.,* 1997, vol. 448, 419-23
- **B.C. KRESS ; P. MEYRUEIS.** Applied Digital Optics. Wiley, 2009